# EUROPEAN PATENT SPECIFICATION

(11) **EP 4 443 673 B1**
(45) Date of publication and mention of the grant of the patent: **29.10.2025**
(21) Application number: 24158599.1
(22) Date of filing: 20.02.2024
(51) Int. Cl.: H01S 5/183, H01S 5/22, H01S 5/30, H01S 5/323, H01S 5/343

(54) **NITRIDE SEMICONDUCTOR STRUCTURE, LIGHT EMITTING ELEMENT, LIGHT SOURCE DEVICE, AND METHOD OF MANUFACTURING NITRIDE SEMICONDUCTOR STRUCTURE**
NITRIDHALBLEITERSTRUKTUR, LICHTEMITTIERENDES ELEMENT, LICHTQUELLENVORRICHTUNG UND VERFAHREN ZUR HERSTELLUNG EINER NITRIDHALBLEITERSTRUKTUR
STRUCTURE SEMI-CONDUCTRICE AU NITRURE, ÉLÉMENT ÉLECTROLUMINESCENT, DISPOSITIF DE SOURCE DE LUMIÈRE ET PROCÉDÉ DE FABRICATION DE STRUCTURE SEMI-CONDUCTRICE AU NITRURE

(30) Priority: 22.03.2023 JP 2023045313
(43) Date of publication of application: 09.10.2024
(73) Proprietor: Ricoh Company, Ltd., Tokyo 143-8555 (JP)
(72) Inventor: KAWASHIMA, Takeshi, 143-8555 Tokyo (JP)
(74) Representative: J A Kemp LLP

(56) References cited:
- WO-A1-2019/044355
- CN-A- 101 019 285
- JP-A- 2017 017 172
- JP-A- 2020 120 051
- US-A- 6 031 858
- US-A1- 2006 187 988
- US-A1- 2020 244 043
- SU CHIA-YING ET AL: "Enhancing the Hole-Injection Efficiency of a Light-Emitting Diode by Increasing Mg Doping in the p-AlGaN Electron-Blocking Layer", IEEE TRANSACTIONS ON ELECTRON DEVICES, IEEE, USA, vol. 64, no. 8, 1 August 2017 (2017-08-01), pages 3226 - 3233, XP011657218, ISSN: 0018-9383, [retrieved on 20170721], DOI: 10.1109/TED.2017.2711023

## Description

### BACKGROUND OF THE INVENTION

### 1. Field of the Invention

The present invention relates to a nitride semiconductor structure, a light emitting element, a light source device, and a method of manufacturing the nitride semiconductor structure.

### 2. Description of the Related Art

In an edge light emitting laser or a surface light emitting laser, in order to efficiently amplify light, a current is narrowed down in a narrow region to cause a population inversion, and light is confined therein to be amplified. For example, a current blocking structure is formed by embedding an n-type semiconductor layer in a region in a p-type semiconductor layer on a side where a wafer surface is formed that does not flow current.

Patent Document 1 discloses a nitride semiconductor structure in which a nitride semiconductor layer containing In such as AlInN is subjected to heat treatment in an atmosphere containing hydrogen to partially evaporate In from the nitride semiconductor layer, thereby forming a current blocking structure.

[Patent Document 1] Japanese Patent Application Laid-Open No. 2020-120051

### SUMMARY OF THE INVENTION

In the method described in Patent Document 1, an in-plane distribution of the In composition of the nitride semiconductor layer is formed, and a region having a different band gap is provided in the plane. The nitride semiconductor structure disclosed in Patent Document 1 has a current blocking structure that makes it difficult for a current to flow in a region having a large band gap. However, simply distributing a region of a different band gap may not be sufficient for current blocking. Therefore, when the nitride semiconductor layer including the current blocking structure is used for a surface light emitting laser, there is a concern that characteristics such as an increase in threshold or the like may be decreased.

The present invention is to provide a nitride semiconductor structure, a light emitting element, a light source device, and a method of manufacturing the nitride semiconductor structure, that can exert stable characteristics.

The scope of the invention is defined by the appended independent claims.

According to an aspect of the disclosed technique, a nitride semiconductor structure includes a nitride semiconductor layer containing Mg as an impurity, the nitride semiconductor layer including a first region and a second region surrounding the first region in a plane parallel to the nitride semiconductor layer, wherein an In composition of the second region is less than an In composition of the first region, and
wherein a hydrogen atom concentration of the second region is higher than a hydrogen atom concentration of the first region by two times or more.

According to the disclosed technique, stable characteristics can be obtained.

### BRIEF DESCRIPTION OF THE DRAWINGS

FIG. 1 is a cross-sectional view illustrating a nitride semiconductor structure according to a first embodiment;
FIG. 2A is a cross-sectional view (No. 1) illustrating a method of manufacturing the nitride semiconductor structure according to the first embodiment;
FIG. 2B is a cross-sectional view (No. 2) illustrating the method of manufacturing the nitride semiconductor structure according to the first embodiment;
FIG. 2C is a cross-sectional view (No. 3) illustrating the method of manufacturing the nitride semiconductor structure according to the first embodiment;
FIG. 2D is a cross-sectional view (No. 4) illustrating the method of manufacturing the nitride semiconductor structure according to the first embodiment;
FIG. 3 is a cross-sectional view illustrating a nitride semiconductor structure according to a second embodiment;
FIG. 4A is a cross-sectional view (No. 1) illustrating a method of the nitride semiconductor structure according to the second embodiment;
FIG. 4B is a cross-sectional view (No. 2) illustrating the method of the nitride semiconductor structure according to the second embodiment;
FIG. 4C is a cross-sectional view (No. 3) illustrating the method of the nitride semiconductor structure according to the second embodiment;
FIG. 5A is a cross-sectional view (No. 1) illustrating the method of manufacturing the nitride semiconductor structure according to the first embodiment, in which a distribution of a concentration of hydrogen atoms and a distribution of an In composition in a current blocking layer are separately formed;
FIG. 5B is a cross-sectional view (No. 2)
   illustrating the method of manufacturing the nitride semiconductor structure according to the first embodiment, in which a distribution of a concentration of hydrogen atoms and a distribution of an In composition in a current blocking layer are separately formed;
FIG. 5C is a cross-sectional view (No. 3)
   illustrating the method of manufacturing the nitride semiconductor structure according to the first embodiment, in which a distribution of a concentration of hydrogen atoms and a distribution of an In composition in a current blocking layer are separately formed;
FIG. 5D is a cross-sectional view (No. 4)
   illustrating the method of manufacturing the nitride semiconductor structure according to the first embodiment, in which a distribution of a concentration of hydrogen atoms and a distribution of an In composition in a current blocking layer are separately formed;
FIG. 6 is a cross-sectional view illustrating a light emitting diode according to a third embodiment;
FIG. 7A is a cross-sectional view (No. 1) illustrating a method of manufacturing the light emitting diode according to the third embodiment;
FIG. 7B is a cross-sectional view (No. 2) illustrating the method of manufacturing the light emitting diode according to the third embodiment;
FIG. 7C is a cross-sectional view (No. 3) illustrating the method of manufacturing the light emitting diode according to the third embodiment;
FIG. 7D is a cross-sectional view (No. 4) illustrating the method of manufacturing the light emitting diode according to the third embodiment;
FIG. 8 is a cross-sectional view illustrating a surface light emitting laser according to a fourth embodiment;
FIG. 9A is a cross-sectional view (No. 1) illustrating a method of manufacturing the surface light emitting laser according to the fourth embodiment;
FIG. 9B is a cross-sectional view (No. 2) illustrating the method of manufacturing the surface light emitting laser according to the fourth embodiment;
FIG. 9C is a cross-sectional view (No. 3) illustrating the method of manufacturing the surface light emitting laser according to the fourth embodiment;
FIG. 9D is a cross-sectional view (No. 4) illustrating the method of manufacturing the surface light emitting laser according to the fourth embodiment;
FIG. 10 is a cross-sectional view illustrating a surface light emitting laser according to a fifth embodiment;
FIG. 11A is a cross-sectional view (No. 1) illustrating a method of manufacturing a surface light emitting laser according to the fifth embodiment;
FIG. 11B is a cross-sectional view (No. 2) illustrating the method of manufacturing the surface light emitting laser according to the fifth embodiment;
FIG. 11C is a cross-sectional view (No. 3) illustrating the method of manufacturing the surface light emitting laser according to the fifth embodiment;
FIG. 11D is a cross-sectional view (No. 4) illustrating the method of manufacturing the surface light emitting laser according to the fifth embodiment;
FIG. 12 is a view illustrating a layout of a projection device according to a sixth embodiment;
FIG. 13 is a view illustrating a layout of a light projection device according to a seventh embodiment;
FIG. 14 is a view illustrating a layout of a projection device according to an eighth embodiment;
FIG. 15 is a perspective view of a configuration example of a head mounted display according to a ninth embodiment;
FIG. 16 is a cross-sectional view of a configuration example of a head mounted display according to a ninth embodiment; and
FIG. 17 is a view illustrating an example of a configuration of a biometric authentication device according to a tenth embodiment.

### DETAILED DESCRIPTION OF THE PREFERRED EMBODIMENTS

Hereinafter, embodiments of the present disclosure will be described with reference to the accompanying drawings. In the specification and the drawings, components having substantially the same functional configuration are denoted by the same reference numerals, and a redundant description thereof may be omitted. In the following description, the side on which the nitride semiconductor layer is located when viewed from the substrate is referred to as the upper side. However, the nitride semiconductor structure or the like can be used in an upside-down state, and can be arranged at an arbitrary angle.

### (First Embodiment)

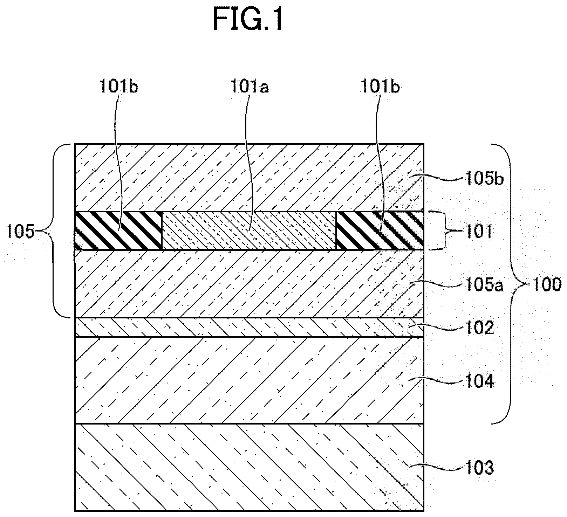

First, a first embodiment will be described. The first embodiment relates to a nitride semiconductor structure. FIG. 1 is a cross-sectional view illustrating a nitride semiconductor structure according to a first embodiment.

As illustrated in FIG. 1, a nitride semiconductor structure 100 according to the first embodiment includes an n-type semiconductor layer 104, an active layer 102 on the n-type semiconductor layer 104, and a p-type semiconductor layer 105 on the active layer 102. Examples of the materials constituting the p-type semiconductor layer 105 include nitride semiconductors such as AlInN, InGaN, AlGaInN, or the like.

The p-type semiconductor layer 105 includes a lower semiconductor layer 105a on the active layer 102, a current blocking layer 101 on the lower semiconductor layer 105a, and an upper semiconductor layer 105b on the current blocking layer 101. The lower semiconductor layer 105a, the current blocking layer 101, and the upper semiconductor layer 105b each contain magnesium (Mg) as an impurity.

The current blocking layer 101 is a layer containing indium (In), and has a first region 101a and a second region 101b surrounding the first region 101a in a plane parallel to the current blocking layer 101. The In composition of the second region 101b is less than the In composition of the first region 101a. Further, a concentration of hydrogen atoms in the second region 101b is higher than a concentration of hydrogen atoms in the first region 101a.

The nitride semiconductor structure 100 is formed on, for example, a substrate 103. As the substrate 103, for example, a substrate on which the nitride semiconductor layer can be laminated is used. As the substrate 103, for example, a nitride semiconductor substrate such as a GaN substrate, an AlN substrate, or the like can be used. As the substrate 103, for example, a GaN template in which a nitride semiconductor layer is formed on a different type of substrate may be used. As the different type of substrate, for example, a sapphire substrate, a Si substrate, a GaAs substrate, a SiC substrate, or the like can be used.

In the nitride semiconductor structure 100, as described above, the In composition of the second region 101b is less than the In composition of the first region 101a. Therefore, a band gap of the second region 101b is larger than a band gap of the first region 101a. Further, the concentration of hydrogen atoms contained in the second region 101b is higher than the concentration of hydrogen atoms contained in the first region 101a. Mg contained in the current blocking layer 101 is bonded to hydrogen atoms and inactivated. The second region 101b has a higher concentration of hydrogen atoms than the first region 101a, and thus the second region 101b has a higher concentration of inactivated Mg. Therefore, the electric resistance of the second region 101b is higher than the electric resistance of the first region 101a. Therefore, in the current blocking layer 101, the current is blocked by the second region 101b having a large band gap and a high electric resistance, and the current selectively flows through the first region 101a. The concentration of hydrogen atoms in the second region 101b is preferably twice or more as high as the concentration of hydrogen atoms in the first region 101a.

The value obtained by dividing the concentration of hydrogen atoms in each of the first region 101a and the second region 101b by the concentration of Mg is defined as the inactivation rate of Mg. When the inactivation rate of Mg in the first region 101a is less than 0.5, more preferably less than 0.3, the first region 101a contains a large amount of activated Mg, and the electric resistance is reduced. When the inactivation rate of the second region 101b is set to 0.5 or more, more preferably 0.9 or more, the amount of activated Mg in the second region 101b is reduced, and the electric resistance is increased. Therefore, the current is more effectively blocked in the second region 101b and more effectively flows in the first region 101a.

When the In composition of the first region 101a and the In composition of the second region 101b are different, not only the current blocking due to the difference in the band gaps but also the light confinement effect due to the difference in a refraction index is generated in the plane of the current blocking layer 101. In general, the higher the In composition, the higher the refractive index of the nitride semiconductor. Therefore, when the In composition of the first region 101a is adjusted to be higher than that of the second region 101b, a refraction index of the first region 101a becomes higher than a refraction index of the second region 101b. Therefore, the light emitted from the active layer 102 is easily confined in a plane parallel to the current blocking layer 101, that is, in a plane parallel to the substrate 103. From the viewpoint of the light confinement effect, the current blocking layer 101 preferably contains Al. This is because the difference in the refractive indices between the first region 101a and the second region 101b can be easily increased. The excellent light confinement effect is extremely suitable for an edge light emitting laser and a surface light emitting laser.

The n-type semiconductor layer 104 is a nitride semiconductor layer doped with impurities such as Si, Ge, or the like. As the n-type semiconductor layer 104, for example, an n-GaN layer, an n-AlGaN layer, or the like can be used. The p-type semiconductor layer 105 is a nitride semiconductor layer doped with Mg as an impurity. As the p-type semiconductor layer 105, for example, a p-GaN layer or a p-AlGaN layer may be used.

The active layer 102 confines carriers injected from the n-type semiconductor layer 104 or the p-type semiconductor layer 105 and emits light, for example. As the active layer 102, for example, in order to obtain high light emitting efficiency, a multi quantum well layer in which InGaN layers and GaN layers are alternately laminated or a multi quantum well layer in which two kinds of InGaN layers having different compositions are alternately laminated, is preferably used.

A thickness of the current blocking layer 101 is not limited, but is preferably 10 nm or more. When the thickness is 10 nm or more, tunneling of holes in the second region 101b can be suppressed. If the current blocking layer 101 is too thick, crystal defects are likely to occur due to the difference in lattice constant between the current blocking layer and other nitride semiconductor layers. Therefore, the thickness of the current blocking layer 101 is preferably equal to or less than the critical film thickness.

The current blocking layer 101 is provided in the p-type semiconductor layer 105, but as for the position in the p-type semiconductor layer 105, the current blocking layer 101 may be disposed at a position in contact with the active layer 102, which is the lowermost portion of the p-type semiconductor layer 105, or may be disposed at the uppermost portion of the p-type semiconductor layer 105, as long as evaporation of In is not hindered in the manufacturing process of the nitride semiconductor structure 100.

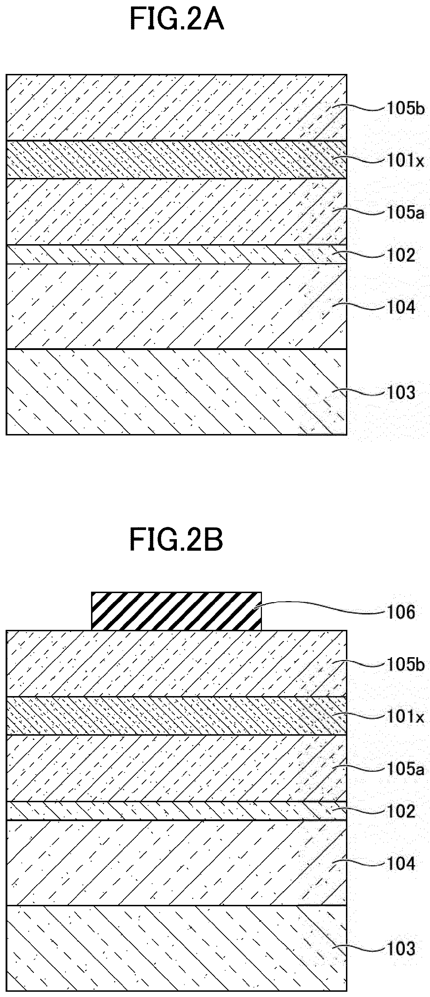

Next, a method of manufacturing the nitride semiconductor structure 100 according to the first embodiment will be described. FIGS. 2A to 2D are cross-sectional views illustrating the method of manufacturing the nitride semiconductor structure 100 according to the first embodiment. In this manufacturing method, the nitride semiconductor layer included in the nitride semiconductor structure 100 is epitaxially grown on the substrate 103. Examples of the epitaxial growth method include a metal organic chemical vapor deposition (MOCVD) method, a molecular beam epitaxy (MBE) method, a plasma chemical vapor deposition (PCVD) method, a hydride vapor phase epitaxy (HVPE) method, or the like. Hereinafter, a case of using the MOCVD method will be described as an example.

First, as illustrated in FIG. 2A, the n-type semiconductor layer 104, the active layer 102, a lower semiconductor layer 105a, an intermediate semiconductor layer 101x, and an upper semiconductor layer 105b are formed on the substrate 103. The intermediate semiconductor layer 101x contains In and has the same composition as the first region 101a. The lower semiconductor layer 105a, the intermediate semiconductor layer 101x, and the upper semiconductor layer 105b are doped with Mg as an impurity. In the MOCVD method, hydrogen atoms of ammonia (NH₃) are incorporated together with Mg to form Mg-H bonds. This inactivates Mg. Therefore, the lower semiconductor layer 105a, the intermediate semiconductor layer 101x, and the upper semiconductor layer 105b are in a state of high electric resistance.

Next, a first heat treatment is performed to activate each of the lower semiconductor layer 105a, the intermediate semiconductor layer 101x, and the upper semiconductor layer 105b. When the heat treatment is performed in an atmosphere not containing hydrogen atoms, hydrogen atoms bonded to Mg in the lower semiconductor layer 105a, the intermediate semiconductor layer 101x, and the upper semiconductor layer 105b are released, and Mg is activated as acceptors. Thus, the lower semiconductor layer 105a, the intermediate semiconductor layer 101x, and the upper semiconductor layer 105b function as p-type electric conductors.

Next, as illustrated in FIG. 2B, a protective mask 106 is formed on the upper semiconductor layer 105b to cover a region where the first region 101a is to be formed. The protective mask 106 may be any material as long as the protective mask can block hydrogen, and for example, a silicon oxide film (SiO₂ film), a silicon nitride film (SiN film), or the like can be used as the protective mask 106.

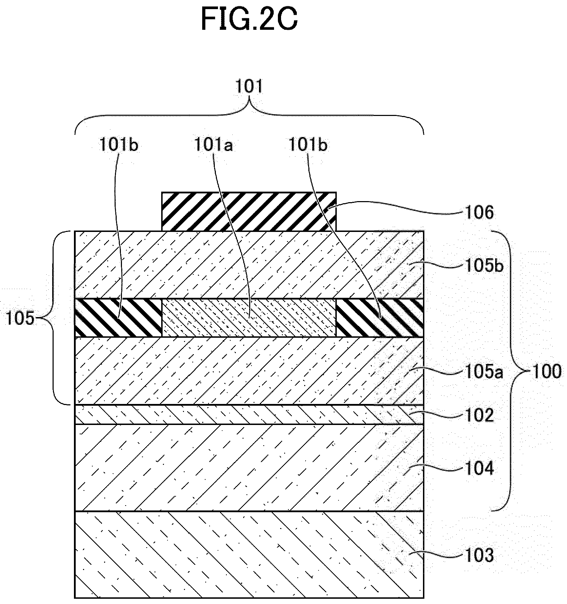

Then, a second heat treatment is performed. The second heat treatment is performed at a temperature of 500°C or higher in an atmosphere containing hydrogen. The second heat treatment allows to evaporate In from the intermediate semiconductor layer 101x not overlapping with the protective mask 106, and further, hydrogen atoms penetrate into the intermediate semiconductor layer 101x not overlapping with the protective mask 106, and Mg is inactivated. As a result, as illustrated in FIG. 2C, the second region 101b having a lower In composition than the intermediate layer 101x and a high Mg inactivation rate is formed. The remaining portion of the intermediate semiconductor layer 101x becomes the first region 101a whose In composition has not changed from the In composition of the intermediate semiconductor layer 101x. In this way, the current blocking layer 101 having the first region 101a and the second region 101b is formed. Further, hydrogen atoms also penetrate into the lower semiconductor layer 105a located below the second region 101b and the upper semiconductor layer 105b located above the second region 101b, and Mg contained in each layer is inactivated. The step of introducing hydrogen atoms into the nitride semiconductors such as the intermediate layer 101x, the lower semiconductor layer 105a, and the upper semiconductor layer 105b is an example of the "hydrogen penetration treatment step".

For the second heat treatment, for example, a film forming device such as an MOCVD device used for forming the n-type semiconductor layer 104, the active layer 102, the lower semiconductor layer 105a, the intermediate semiconductor layer 101x, and the upper semiconductor layer 105b can be used. A heat treatment apparatus or the like may be used.

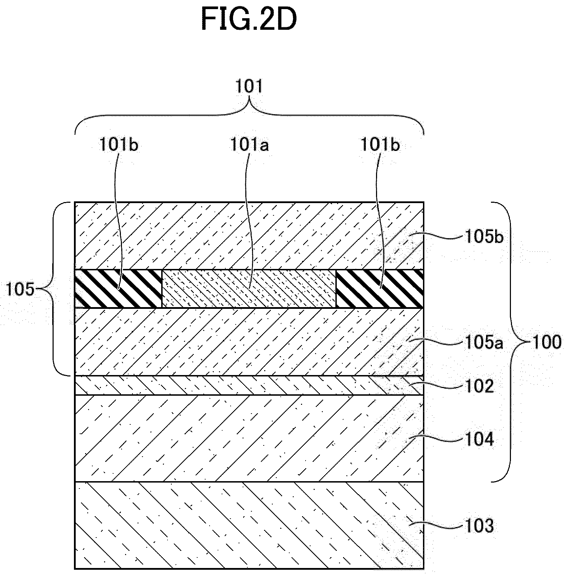

Subsequently, as illustrated in FIG. 2D, the protective mask 106 is removed.

In this way, the nitride semiconductor structure 100 of the first embodiment can be manufactured.

According to this method, an in-plane band gap distribution and an in-plane hydrogen atom concentration distribution based on the difference of the In compositions are obtained in the intermediate semiconductor layer 101x. In other words, an electric resistance distribution caused by the difference in the inactivation rate of Mg is formed in the plane of the intermediate semiconductor layer 101x. In addition, an electric resistance distribution due to the difference in the inactivation rate of Mg is generated in the plane of the lower semiconductor layer 105a and the upper semiconductor layer 105b, and thus very stable characteristics of the current blocking structure can be obtained. Furthermore, the distribution of the In composition causes a difference in refractive index in the plane, and thus light generated in the active layer 102 can be confined.

Although the intermediate layer 101x is disposed in the p-type semiconductor layer 105 in the above description, if the upper semiconductor layer 105b is too thick, the desorption of hydrogen atoms by the Mg activation process in the first heat treatment and the penetration of hydrogen atoms by the second heat treatment are not substantially affected, but In is not easily evaporated in the second heat treatment. Therefore, the thickness of the upper semiconductor layer 105b is preferably 100 nm or less, more preferably 50 nm or less, and even more preferably 10 nm or less.

### (Second Embodiment)

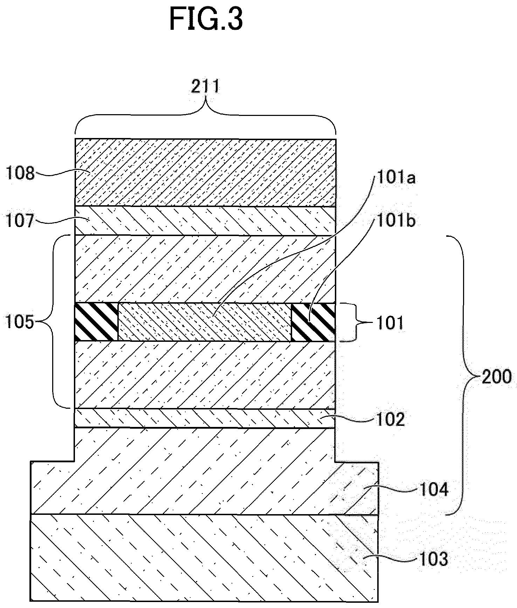

Next, a second embodiment will be described. The second embodiment relates to a nitride semiconductor structure. FIG. 3 is a cross-sectional view illustrating the nitride semiconductor structure of the second embodiment.

As illustrated in FIG. 3, a nitride semiconductor structure 200 according to the second embodiment includes an n-type semiconductor layer 104, an active layer 102, a p-type semiconductor layer 105, a tunnel bonding layer 107, and an upper n-type semiconductor layer 108. The p-type semiconductor layer 105 includes a current blocking layer 101 as a nitride semiconductor layer containing Mg as an impurity. The upper n-type semiconductor layer 108, the tunnel bonding layer 107, the p-type semiconductor layer 105, the current blocking layer 101, the active layer 102, and a part of the n-type semiconductor layer 104 are etched to form a mesa structure 211.

The planar shape of the mesa structure 211 is not particularly limited. For example, when the nitride semiconductor structure 200 is used for an edge light emitting laser, the mesa structure 211 is formed in a stripe shape. For example, when the nitride semiconductor structure 200 is used for a surface light emitting laser, the mesa structure 211 is formed in a circular shape or a rectangular shape.

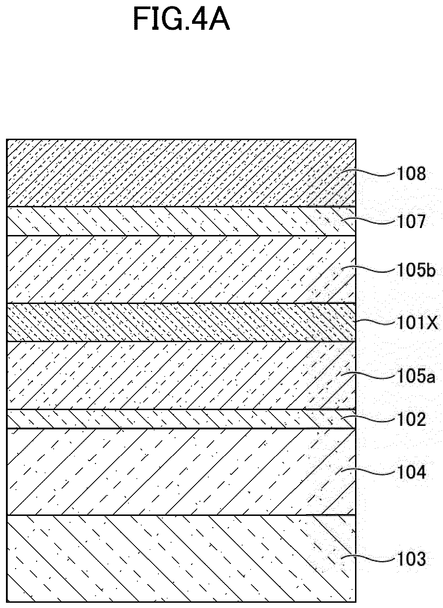

Next, a method of manufacturing the nitride semiconductor structure 200 according to the second embodiment will be described. FIGS. 4A to 4C are cross-sectional views illustrating the method of manufacturing the nitride semiconductor structure 200 of the second embodiment. In this manufacturing method, the nitride semiconductor layers included in the nitride semiconductor structure 200 are epitaxially grown on the substrate 103.

First, as illustrated in FIG. 4A, the n-type semiconductor layer 104, the active layer 102, the lower semiconductor layer 105a, the intermediate semiconductor layer 101x, the upper semiconductor layer 105b, the tunnel bonding layer 107, and the upper n-type semiconductor layer 108 are formed on the substrate 103. The tunnel bonding layer 107 consists of two layers of p-type and n-type semiconductors doped with high concentrations of impurities, with the p-type semiconductor on the substrate side and the n-type semiconductor on the surface side.

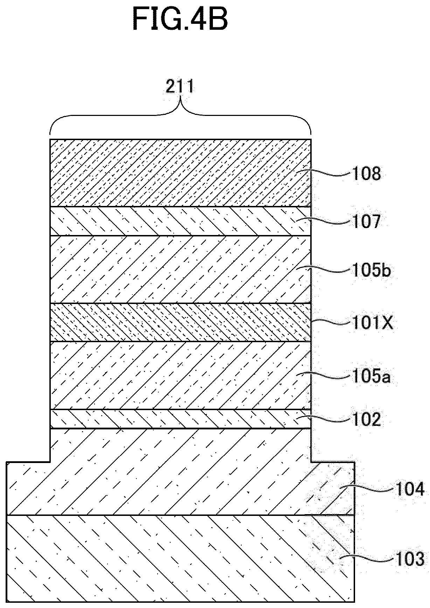

Next, as illustrated in FIG. 4B, the upper n-type semiconductor layer 108, the tunnel bonding layer 107, the lower semiconductor layer 105a, the intermediate semiconductor layer 101x, the upper semiconductor layer 105b, the intermediate semiconductor layer 101x, the active layer 102, and a part of the n-type semiconductor layer 104 are removed by lithography and dry etching, thereby forming the mesa structure 211.

Thereafter, the lower semiconductor layer 105a, the intermediate semiconductor layer 101x, and the upper semiconductor layer 105b are activated by the first heat treatment. It is known that, when an n-type nitride semiconductor layer is formed on a p-type nitride semiconductor layer, hydrogen atoms bonded to Mg in the p-type nitride semiconductor layer are less likely to pass through the n-type nitride semiconductor layer during activation treatment. Therefore, the mesa structure 211 is formed to desorb hydrogen atoms from the sidewall of the mesa structure 211.

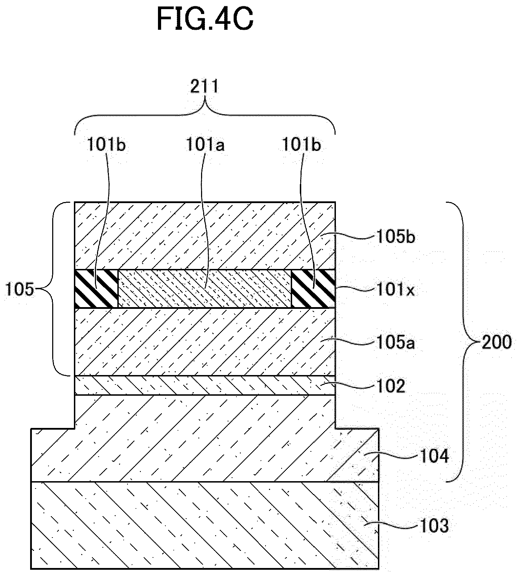

Next, a second heat treatment is performed at a temperature of 500°C or higher in an atmosphere containing hydrogen. The second heat treatment allows to permeate hydrogen atoms from the sidewall of the mesa structure 211, so that In in the intermediate semiconductor layer 101x evaporates from the sidewall, and the p-type semiconductor layer 105 is also inactivated from the sidewall. As a result, as illustrated in FIG. 4C, the second region 101b having a lower In composition than the intermediate semiconductor layer 101x and a high Mg inactivation rate is formed. The remaining portion of the intermediate semiconductor layer 101x becomes the first region 101a whose In composition has not changed from the In composition of the intermediate semiconductor layer 101x. In this way, the current blocking layer 101 having the first region 101a and the second region 101b is formed.

Accordingly, the nitride semiconductor structure 200 of the second embodiment can be manufactured.

According to this method, a plane band gap distribution and a plane hydrogen atom concentration distribution based on the difference of the In compositions are obtained in the intermediate semiconductor layer 101x. In other words, an electric resistance distribution caused by the difference in the inactivation rate of Mg is formed in the plane of the intermediate semiconductor layer 101x. In addition, the electric resistance distribution is generated due to the difference in the inactivation rate of Mg in the plane of each of the lower and upper semiconductor layers 105a and 105b, and thus very stable characteristics of the current blocking structure can be obtained. Furthermore, the distribution of the In composition causes a difference in the refractive index in the plane, and light generated in the active layer 102 can be confined.

The mesa structure 211 may be formed to such an extent that at least the sidewall of the p-type semiconductor layer 105 is exposed.

In addition, there is no need for a steep and discontinuous change in the In composition between the first region 101a and the second region 101b. A region of continuously varying the In composition may exist between the first region 101a and the second region 101b.

In the first and second embodiments, the atmosphere of the second heat treatment may be an atmosphere of only hydrogen gas or an atmosphere of a mixed gas of hydrogen gas and an inert gas such as nitrogen gas. The evaporation rate of In can be controlled according to the ratio of the inert gas. The atmosphere of the second heat treatment may be an atmosphere containing ammonia in addition to a hydrogen gas. Nitrogen in the nitride semiconductor layer may be desorbed during the heat treatment to roughen the exposed surface. However, when the atmosphere contains ammonia, the desorption of nitrogen is suppressed, and the exposed surface is easily kept flat. Further, ammonia also contains hydrogen atoms, and therefore can inactivate Mg.

The heat treatment temperature of the second heat treatment is not limited as long as In can be evaporated, and is, for example, 500°C or higher as described above. When a temperature capable of depositing the intermediate semiconductor layer 101x to be a current blocking layer with a good crystallinity is set to a temperature T(°C), the heat treatment temperature is preferably T-200(°C) or higher and more preferably T-100(°C) or higher. On the other hand, the heat treatment temperature is preferably equal to or lower than the temperature at which the intermediate semiconductor layer 101x decomposes. For example, when the intermediate semiconductor layer 101x is an InGaN layer, Ga starts to evaporate in a temperature range of 1,100°C to 1,200°C. Therefore, when the heat treatment temperature exceeds 1,200°C, the intermediate semiconductor layer 101x is decomposed before the current blocking layer 101 is formed. Therefore, when the intermediate semiconductor layer 101x is an InGaN layer, the heat treatment temperature is preferably 1,200°C or lower and more preferably 1,100°C. For example, when the intermediate semiconductor layer 101x is an AlInN layer or an AlGaInN layer, a thermal decomposition of the intermediate semiconductor layer 101x is suppressed by Al contained in the intermediate semiconductor layer 101x, and the heat treatment temperature can be increased to 1,400°C. The temperature T depends on the In composition of the intermediate semiconductor layer 101x, and the temperature T tends to increase as the In composition decreases.

The order of the steps of activating Mg by the first heat treatment and evaporating In by the second heat treatment may be changed, and a step of causing hydrogen atoms to penetrate may be further introduced. Thus, a third region having an In composition lower than that of the first region 101a and a concentration of hydrogen atoms lower than that of the second region 101b or a third region having an In composition higher than that of the second region 101b and a concentration of hydrogen atoms higher than that of the first region 101a, is formed between the first region 101a and the second region 101b, whereby the distribution of the in-plane electric resistance and the distribution of the in-plane refractive-index can be controlled separately.

For example, after the nitride semiconductor structure 100 of FIG. 1 is prepared, when the protective mask 106 is formed on the upper semiconductor layer 105b without performing the first heat treatment for activating Mg and In is evaporated by performing the second heat treatment, In is evaporated from the region of the intermediate semiconductor layer 101x where the protective mask 106 is not formed, and the in-plane distribution of the In composition of the first region 101a and the second region 101b is formed in the intermediate semiconductor layer 101x, as illustrated in 5A of FIG. 1, but the distribution of the concentration of hydrogen atoms bonded to Mg in the p-type semiconductor layer 105 does not change.

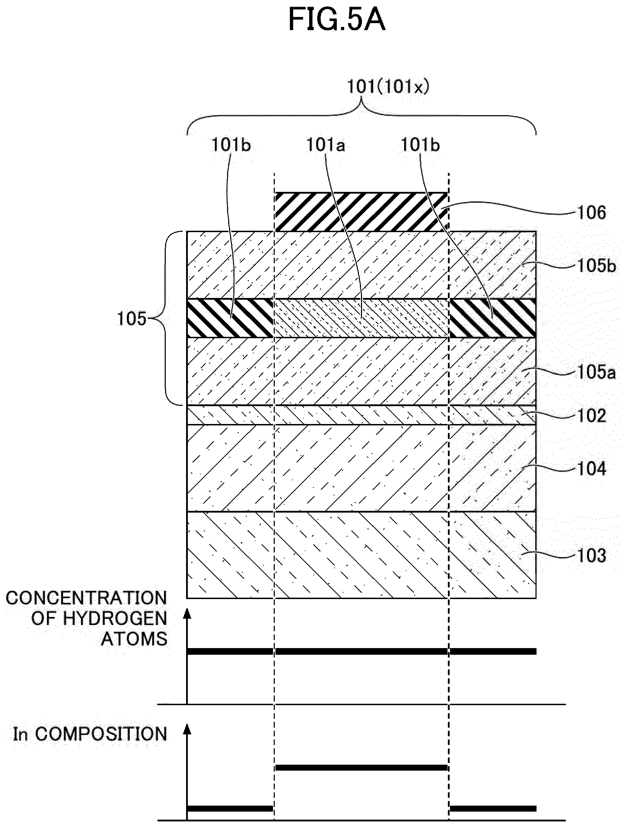

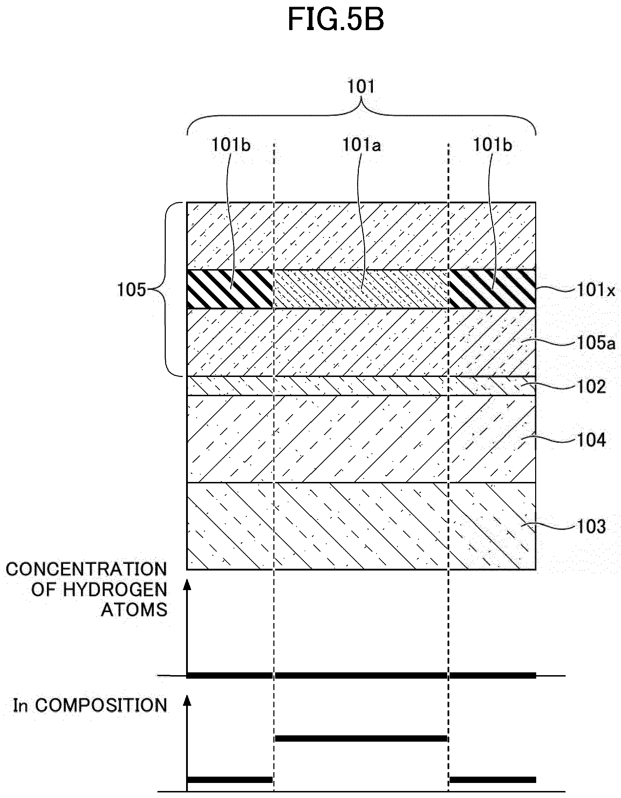

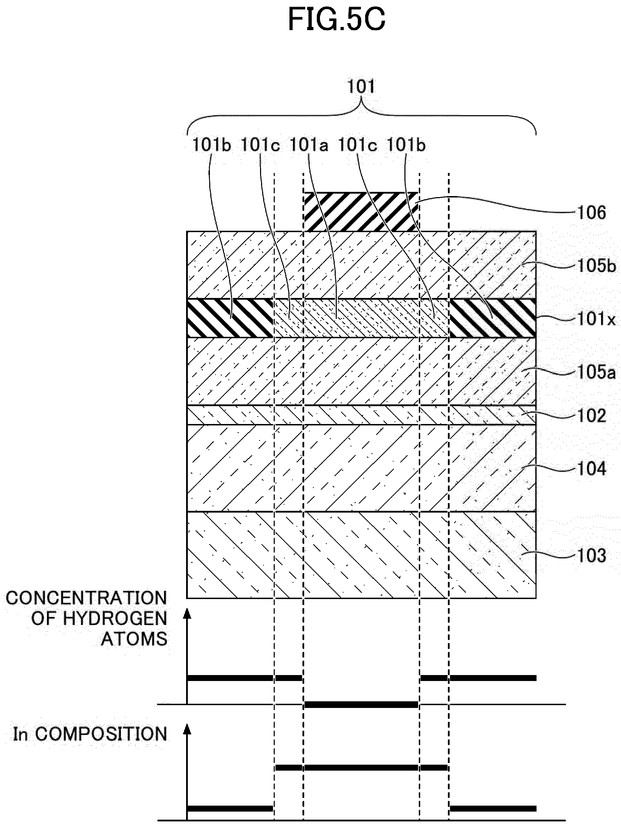

On the other hand, when the first heat treatment is performed, as illustrated in FIG. 5B, hydrogen atoms in the p-type semiconductor layer 105 are desorbed, and the concentration of hydrogen atoms in the entire plane decreases. Next, a protective mask 106 is newly formed on the surface of the p-type semiconductor layer 105, and hydrogen atoms are allowed to permeate, thereby forming an in-plane hydrogen atom concentration distribution. For example, as illustrated in FIG. 5C, when the width of the protective mask 106 is reduced and hydrogen atoms are allowed to penetrate to the center of the intermediate semiconductor layer 101x, a third region 101c having a In composition higher than that of the second region 101b and a concentration of hydrogen atoms higher than that of the first region 101a is formed between the first region 101a and the second region 101b. At this time, if the heat treatment is performed in a hydrogen-containing atmosphere, In in the third region 101c is evaporated, and thus, for example, hydrogen atoms are introduced by proton implantation or the like.

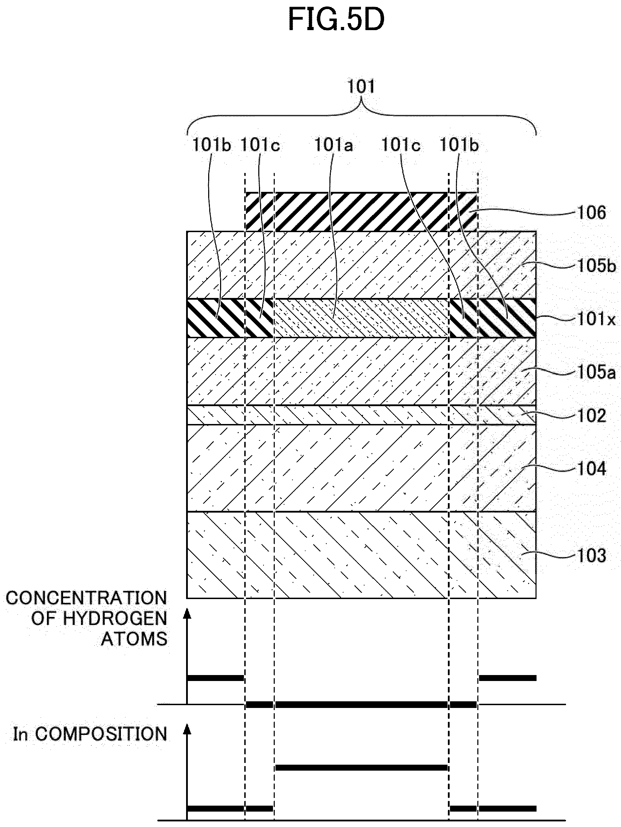

In another embodiment, as illustrated in FIG. 5D, when the protective mask 106 is formed so that a width of the protective mask is wider than the first region 101a, a third region 101c having an In composition lower than that of the first region 101a and a concentration of hydrogen atoms lower than that of the second region 101b is formed between the first region 101a and the second region 101b. In this example, the third region 101c is protected by the protective mask 106, and evaporation of In due to permeation of hydrogen atoms does not occur.

In the nitride semiconductor structure 200 of the second embodiment, the order of the steps of activating Mg by the first heat treatment and evaporating In by the second heat treatment is changed after the mesa structure is formed, and a step of allowing hydrogen to permeate is separately introduced, whereby the in-plane electric resistance distribution and the in-plane refractive index distribution can be separately controlled in the same manner.

As described above, the electrical resistance distribution due to the inactivation of Mg and the refractive index distribution due to the difference in the In composition are separately formed in the plane, and thus, characteristics as desired can be obtained.

### (Third Embodiment)

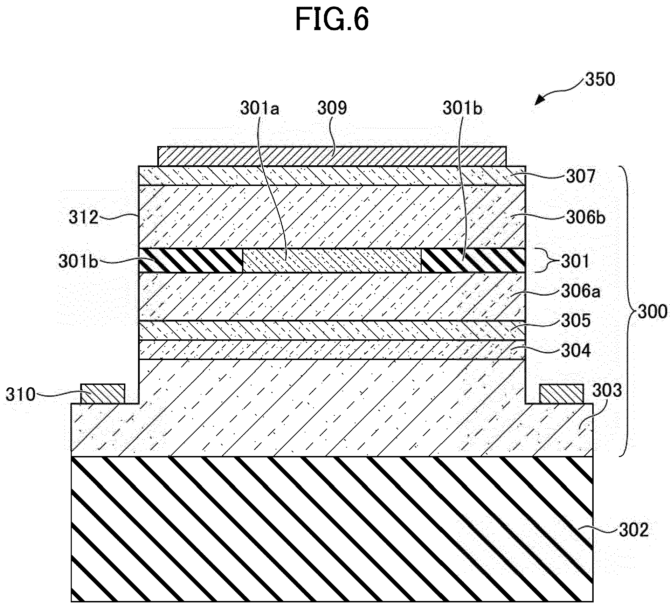

Next, a third embodiment will be described. The third embodiment relates to a light emitting diode having a nitride semiconductor structure. The light emitting diode is an example of a light emitting element. FIG. 6 is a cross-sectional view illustrating the light emitting diode according to the third embodiment.

As illustrated in FIG. 6, a light emitting diode 350 according to the third embodiment includes a sapphire substrate 302 and a light emitting diode (LED) structure 300 on the sapphire substrate 302. The LED structure 300 includes an n-GaN layer 303, a multi quantum well layer 304, a p-Al_{0.20}Ga_{0.80}N layer 305, a p-GaN layer 306a, a current blocking layer 301, a p-GaN layer 306b, and a p⁺⁺-GaN layer 307. The p-GaN layer 306a is an example of a lower semiconducting layer, the p-GaN layer 306b is an example of an upper semiconducting layer, and the current blocking layer 301 is an example of a nitride semiconductor layer containing Mg as an impurity. The LED structure 300 is an example of a nitride semiconductor structure.

The n-GaN layer 303 is formed on the sapphire substrate 302. The thickness of the n-GaN layer 303 is, for example, 5 µm.

The multi quantum well layer 304 is formed on the n-GaN layer 303. The multi quantum well layer 304 has a structure in which, for example, In_{0.15}Ga_{0.85}N layers with a thickness of 2.5 nm and GaN layers with a thickness of 7.5 nm are alternately laminated for five cycles. The multi quantum well layer 304 is an example of an active layer.

The p-Al_{0.20}Ga_{0.80}N layer 305 is formed on the multi quantum well layer 304. The p-Al_{0.20}Ga_{0.80}N layer 305 is, for example, a thickness of 20nm.

The p-GaN layer 306a is formed on the p-Al_{0.20}Ga_{0.80}N layer 305. A thickness of the p-GaN layer 306a is, for example, 50 nm.

The current blocking layer 301 is formed on the p-GaN layer 306a. A thickness of the current blocking layer 301 is, for example, 50 nm. The current blocking layer 301 includes a p-Al_{0.70}In_{0.30}N layer 301a and a p-AlN layer 301b surrounding the p-Al_{0.70}In_{0.30}N layer in a plane parallel to the current blocking layer 301. As described above, the In composition of the p-AlN layer 301b is less than the In composition of the p-Al_{0.70}In_{0.30}N layer 301a. The p-Al_{0.70}In_{0.30}N layer 301a is an example of a first region, and the p-AlN layer 301b is an example of a second region.

The p-GaN layer 306b is formed on the current blocking layer 301. A thickness of the p-GaN layer 306b is, for example, 50 nm.

The p⁺⁺-GaN layer 307 is formed on the p-GaN layer 306b. A thickness of the p⁺⁺-GaN layer 307 is, for example, 5 nm. The p⁺⁺-GaN layer 307 is doped with Mg as acceptors at a concentration of 1 × 10²⁰cm⁻³.

An isolation groove 312 is formed in the p⁺⁺-GaN layer 307, the p-GaN layer 306b, the current blocking layer 301, the p-GaN layer 306a, the p-Al_{0.20}Ga_{0.80}N layer 305, the multi quantum well layer 304, and a part of the n-GaN layer 303.

Ap-side electrode 309 is formed on the surface of the p⁺⁺-GaN layer 307. An n-side electrode 310 is formed on the surface of the n-GaN layer 303 exposed from the isolation groove 312. The p-side electrode 309 includes, for example, a Ni film and an Au film laminated in this order from the p⁺⁺-GaN layer 307 side. The n-side electrode 310 includes, for example, a Ti film and an Al film laminated in this order from the n-GaN layer 303 side.

In the light emitting diode 350, as described above, the current blocking layer 301 includes the p-Al_{0.70}In_{0.30}N layer 301a and the p-AlN layer 301b. The band gap of the pAl_{0.70}In_{0.30}N layer 301a is 3.59 eV, and the band gap of the p-AlN layer 301b is 6.2 eV. Thus, the band gap of the p-AlN layer 301b is larger than the band gap of the p-Al_{0.70}In_{0.30}N layer 301a by 1.0 eV or more. Therefore, a large band offset is formed between the p-AlN layer 301b and each of the p-Al_{0.70}In_{0.30}N layer 301a, p-GaN layer 306a, and p-GaN layer 306b.

Furthermore, by a manufacturing method described later, among the planes of p-AlN layer 301b, p-GaN layer 306a, and p-GaN layer 306b, the concentration of hydrogen atoms in the region where the p-AlN layer 301b is formed, is higher than the concentration of hydrogen atoms in the region where the p-Al_{0.70}In_{0.30}N layer 301a is formed among the planes of the pAl_{0.70}In_{0.30}N layer 301a, the p-GaN layer 306a, and the p-GaN layer 306b. Therefore, inside the current blocking layer 301, the current selectively flows through the p-Al_{0.70}In_{0.30}N layer 301a.

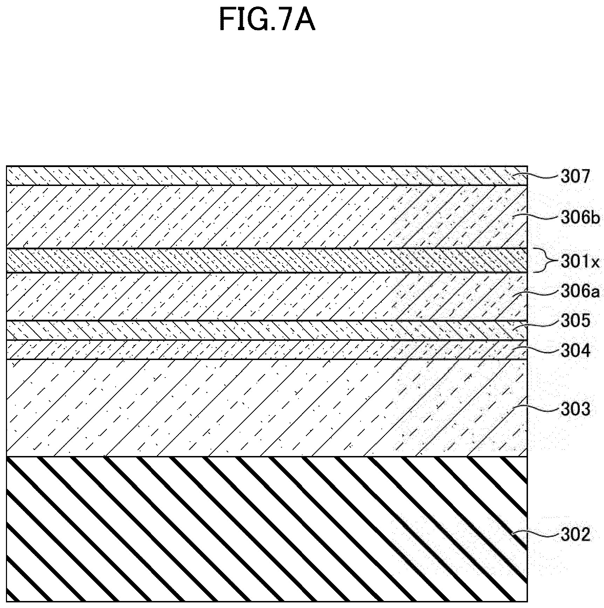

Next, a method of manufacturing the light emitting diode 350 according to the third embodiment will be described. FIGS. 7A to 7D are cross-sectional views illustrating the method of manufacturing the light emitting diode 350 according to the third embodiment. In this manufacturing method, nitride semiconductor layers included in the LED structure 300 are epitaxially grown on the sapphire substrate 302.

First, as illustrated in FIG. 7A, an n-GaN layer 303, a multi quantum well layer 304, a p-Al_{0.20}Ga_{0.80}N layer 305, a p-GaN layer 306a, and a p-Al_{0.70}In_{0.30}N layer 301x are sequentially formed on a sapphire substrate 302 using an MOCVD device. Before the n-GaN layer 303 is formed, a GaN buffer layer (not illustrated) having a thickness of, for example, 20 nm of a buffer layer may be formed on the sapphire substrate 302.

Mg in the p-Al_{0.20}Ga_{0.80}N layer 305, the p-GaN layer 306a, the p-Al_{0.70}In_{0.30}N layer 301x, the p-GaN layer 306b, and the p⁺⁺-GaN layer 307 (hereinafter, collectively referred to as p-type layers) is doped at 1×10²⁰cm⁻³ in the p⁺⁺-GaN layer 307 and at 2×10¹⁹cm⁻³ in the other layers. In the p-type layer, hydrogen atoms derived from ammonia gas used for film formation in the MOCVD device are incorporated at the same concentration as Mg in the p-type layer and inactivated (inactivation rate: 1.0). Therefore, as the first heat treatment, the structure illustrated in FIG. 7A is put in a heat treatment apparatus and heat treatment is performed at 900°C under a nitride atmosphere. For example, the heat treatment time is set to 10 minutes. Although depending on the temperature and time of the heat treatment and the atmosphere gas, 70% of hydrogen atoms are desorbed from the p-type layer (inactivation rate: 0.30) by the heat treatment, and the p-type layer exhibits p-type conductivity.

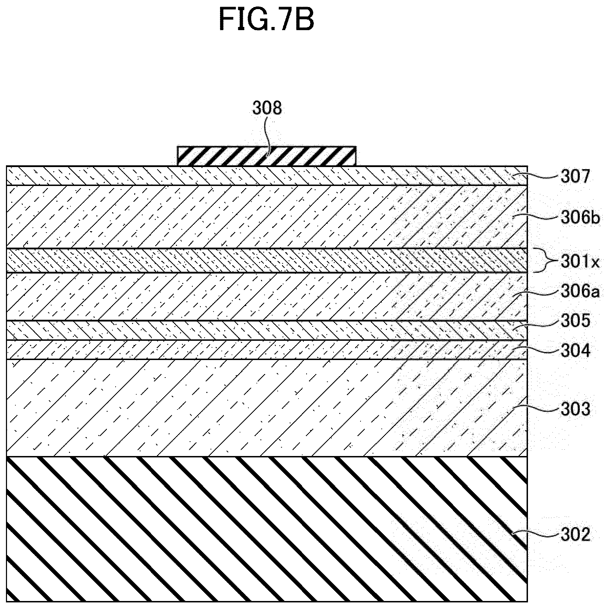

Next, the structure illustrated in FIG. 7A is taken out from the MOCVD device, and as illustrated in FIG. 7B, a SiO₂ film 308 having a thickness of, for example, 100 nm is formed on the p⁺⁺-GaN layer 307 as a protective mask covering a region where the pAl_{0.70}In_{0.30}N layer 301a is to be formed. The SiO₂ film 308 can be formed by, for example, photolithography.

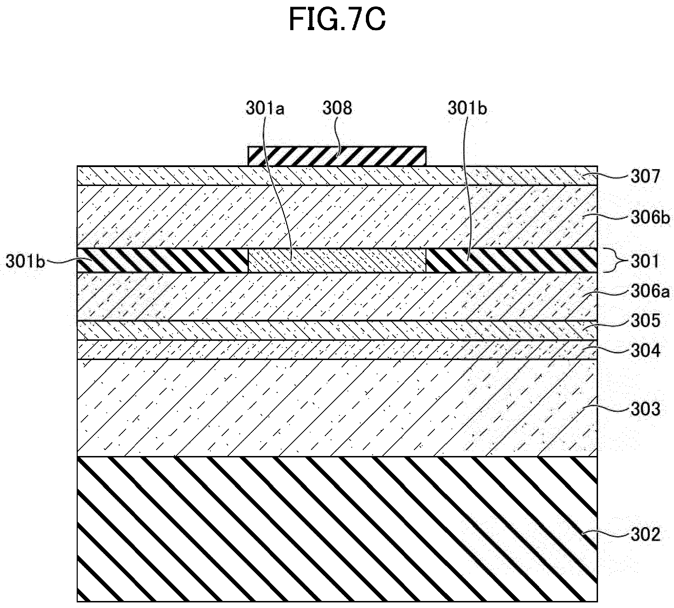

After that, the structure illustrated in FIG. 7B is put in a heat treatment apparatus, and heat treatment is performed at 800°C in a hydrogen-containing atmosphere as second heat treatment. The time of the heat treatment is, for example, 10 minutes. By this heat treatment, hydrogen atoms permeate from the front side of the sapphire substrate 302 into the region not protected by the SiO₂ film 308, and In evaporates from the portion of the pAl_{0.70}In_{0.30}N layer 301x not protected by the SiO₂ film 308. As a result, as illustrated in FIG. 7C, the region of the p-Al_{0.70}In_{0.30}N layer 301x not protected by the SiO₂ film 308 is changed to the p-AlN layer 301b. The remaining portion of the p-Al_{0.70}In_{0.30}N layer 301x becomes a p-Al_{0.70}In_{0.30}N layer 301a whose In composition has not changed from the In composition of the p-Al_{0.70}In_{0.30}N layer 301x. In this way, the current blocking layer 301 having the pAl_{0.70}In_{0.30}N layer 301a and the p-AlN layer 301b is formed. Further, hydrogen atoms having the same concentration as Mg in the p-type layer in the region where the SiO₂ film 308 is not formed are taken in, and Mg is inactivated. Thus, an electrical resistance distribution is formed in the p-type layer.

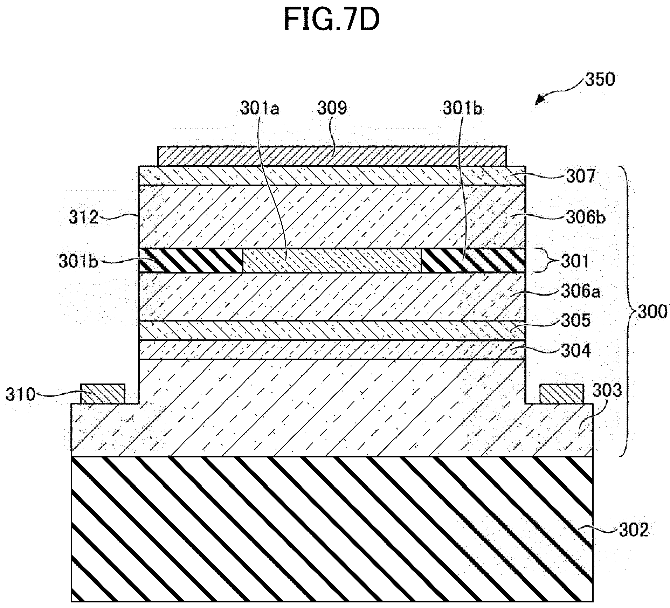

Subsequently, the structure illustrated in FIG. 7C is taken out from the heat treatment apparatus, and the SiO₂ film 308 is removed as illustrated in FIG. 7D. The SiO₂ film 308 can be removed by using, for example, buffered hydrofluoric acid.

Thereafter, as illustrated in FIG. 7D, an isolation groove 312 is formed in the p⁺⁺-GaN layer 307, the p-GaN layer 306b, the current blocking layer 301, the p-GaN layer 306a, the p-Al_{0.20}Ga_{0.80}N layer 305, the multi quantum well layer 304, and a part of the n-GaN layer 303.

The isolation groove 312 can be formed by, for example, lithography and dry etching. Next, a p-side electrode 309 is formed on the surface of the p⁺⁺-GaN layer 307, and n-side electrodes 310 are formed on the surface of the portion of the n-GaN layer 303 exposed from the isolation groove 312. In the formation of the p-side electrode 309, for example, a Ni film and an Au film are laminated in this order from the p⁺⁺-GaN layer 307 side. In the formation of the n-side electrodes 310, for example, a Ti film and an Al film are laminated in this order from the n-GaN layer 303 side.

In this way, the light emitting diode 350 according to the third embodiment can be manufactured.

According to this method, a plane band gap distribution and a plane hydrogen atom concentration distribution based on the difference of the In compositions are obtained in the p-Al_{0.70}In_{0.30}N layer 301x. In other words, an electrical resistance distribution is formed due to the difference in the inactivation rate of Mg. Further, the electric resistance distribution is generated due to the difference in the inactivation rate of Mg in the plane of the p-GaN layer 306a and the p-GaN layer 306b, and very stable characteristics of the current blocking structure can be obtained.

### (Fourth Embodiment)

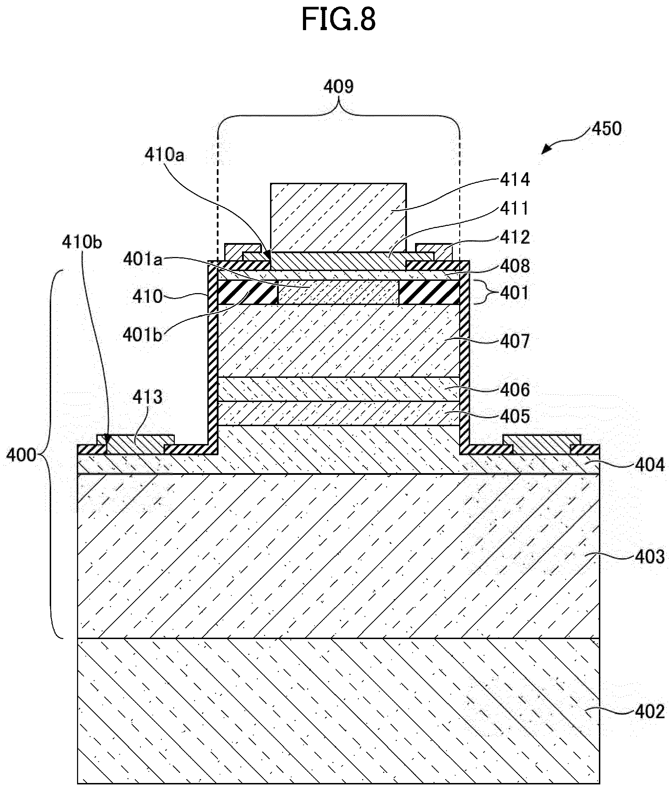

Next, a fourth embodiment will be described. The fourth embodiment relates to a surface light emitting laser including a nitride semiconductor structure. The surface light emitting laser is an example of a light emitting element. FIG. 8 is a cross-sectional view illustrating a surface light emitting laser according to the fourth embodiment.

As illustrated in FIG. 8, the surface light emitting laser 450 according to the fourth embodiment includes an n-GaN substrate 402 and a laser structure 400 on the n-GaN substrate 402. The laser structure 400 includes a lower multilayer film reflector 403, an n-GaN layer 404, a multi quantum well layer 405, a p-Al_{0.20}Ga_{0.80}N layer 406, a p-GaN layer 407, a current blocking layer 401, and a p⁺⁺-GaN layer 408. The p-GaN layer 407 is an example of a lower semiconductor layer, the p⁺⁺-GaN layer 408 is an example of an upper semiconductor layer, and the current blocking layer 401 is an example of a nitride semiconductor layer containing Mg as an impurity. The laser structure 400 is an example of a nitride semiconductor structure.

The lower multilayer film reflector 403 is formed on the n-GaN substrate 402. The lower multilayer film reflector 403 has a structure in which a high refractive index layer and a low refractive index layer are alternately laminated for 46 cycles. The high refractive index layer is, for example, an In_{0.05}Ga_{0.95}N layer having a thickness of 50 nm. The low refractive index layer has, for example, a multilayer structure with two AlN layers, each of the AlN layers having a thickness of 6 nm, inserted between three GaN layers, each of the GaN layers having a thickness of 6 nm.

The n-GaN layer 404 is formed on the lower multilayer film reflector 403. The thickness of the n-GaN layer 404 is, for example, 1.1 µm.

The multi quantum well layer 405 is formed on the n-GaN layer 404. The multi quantum well layer 405, for example, has a structure consisting of five alternating cycles of In_{0.10}Ga_{0.90}N layers, each of the In_{0.10}Ga_{0.90}N layers having a thickness of 4 nm and GaN layers, each of the GaN layer having a thickness of 6 nm. The multi quantum well layer 405 is an example of an active layer.

The p-Al_{0.20}Ga_{0.80}N layer 406 is formed on the multi quantum well layer 405. The thickness of the p-Al_{0.20}Ga_{0.80}N layer 406 is, for example, 20 nm.

The p-GaN layer 407 is formed on the p-Al_{0.20}Ga_{0.80}N layer 406. The thickness of the p-GaN layer 407 is, for example, a 75 nm. The p-GaN layer 407 is doped with Mg as acceptors at a concentration of 2×10¹⁹cm⁻³.

The current blocking layer 401 is formed on the p-GaN layer 407. The thickness of the current blocking layer 401 is, for example, 35 nm. The current blocking layer 401 includes a p-Al_{0.70}In_{0.30}N layer 401a and a p-Al_{0.90}In_{0.10}N layer 401a that surrounds the pAl_{0.70}In_{0.30}N layer 401a in the plane parallel to the current blocking layer 401. As described above, the In composition of the p-Al_{0.90}In_{0.10}N layer 401b is less than the In composition of the p-Al_{0.70}In_{0.30}N layer 401a. The p-Al_{0.70}In_{0.30}N layer 401a is an example of a first region, and the p-Al_{0.90}In_{0.10}N layer 401b is an example of a second region.

The p⁺⁺-GaN layer 408 is formed on the current blocking layer 401. The thickness of the p⁺⁺-GaN layer 408 is, for example, 10 nm. The p⁺⁺-GaN layer 408 is doped with Mg as acceptors at a concentration of 1×10²⁰cm⁻³.

In the laser structure 400, the p⁺⁺-GaN layer 408, the current blocking layer 401, the p-GaN layer 407, the p-Al_{0.20}Ga_{0.80}N layer 406, the multi quantum well layer 405, and a part of the n-GaN layer 404 are etched to form a mesa structure 409.

A SiN film 410 is formed as a passivation film so as to cover the front surface and the side surface of the mesa structure 409 and the front surface of the n-GaN layer 404. The SiN film 410 has an opening 410a exposing a part of the p⁺⁺-GaN layer 408 and an opening 410b exposing a part of the n-GaN layer 404. For example, the p-Al_{0.70}In_{0.30}N layer 401a is located inside of the opening 410a in a plan view.

An indium tin oxide (ITO) film 411 is formed on the p⁺⁺-GaN layer 408 so as to rise on the SiN film 410 through the opening 410a. An upper electrode 412 having a ring-like planar shape is formed on the SiN film 410 and the ITO film 411 at the upper portion of the mesa structure 409. Inside of the upper electrode 412, a dielectric distributed Bragg reflector (DBR) 414 is formed on the ITO film 411. On the surface of the n-GaN layer 404, lower electrodes 413 are formed so that the lower electrode 413 rises on the SiN film 410 through the opening 410b.

The upper electrode 412 includes, for example, a Ti film and an Au film laminated in this order from the side where the SiN film 410 and the ITO film 411 are provided. The lower electrode 413 includes, for example, a Ti film and an Al film laminated in this order from the side where the n-GaN layer 404 is provided. The DBR 414 includes, for example, a tantalum oxide film (Ta₂O₅ film) and a SiO₂ film. The lower multilayer film reflector 403 and the DBR 414 constitute a resonator structure.

In the surface light emitting laser 450, as described above, the current blocking layer 401 includes the p-Al_{0.70}In_{0.30}N layer 401a and the p-Al_{0.90}In_{0.10}N layer 401b. The band gap of the p-Al_{0.70}In_{0.30}N layer 401a is 3.59 eV, and the band gap of the p-Al_{0.90}In_{0.10}N layer 401b is 5.24 eV.

The band gap of the p-GaN layer 407 and the p⁺⁺-GaN layer 408 sandwiching the current blocking layer 401 is 3.4 eV. As described above, the band gap of the p-Al_{0.90}In_{0.10}N layer 401b is larger than the band gap of any of the p-Al_{0.70}In_{0.30}N layer 401a, the p-GaN layer 407, and the p⁺⁺-GaN layer 408 existing around the p-Al_{0.90}In_{0.10}N layer 401b by 1.0 eV or more. Therefore, a large band offset is formed between the p-Al_{0.90}Ih_{0.10}N layer 401b and the p-Al_{0.70}In_{0.30}N layer 401a, the p-GaN layer 407, and the p⁺⁺-GaN layer 408.

Further, by a manufacturing method described later, among the planes of the pAl_{0.90}In_{0.10}N layer 401b, the p-Al_{0.70}In_{0.30}N layer 401a, the p-GaN layer 407, and the p⁺⁺-GaN layer 408, the concentration of hydrogen atoms in the region where the p-Al_{0.90}In_{0.10}N layer 401b is formed is higher than the concentration of hydrogen atoms in the region where the pAl_{0.70}In_{0.30}N layer 401a is formed among the planes of the p-Al_{0.70}In_{0.30}N layer 401a, the p-GaN layer 407, and the p⁺⁺-GaN layer 408.

Therefore, in the current blocking layer 401, the current is blocked by the pAl_{0.90}In_{0.10}N layer 401b, and the current selectively flows through the p-Al_{0.70}In_{0.30}N layer 401a.

Further, since the refractive index of the p-Al_{0.90}In_{0.10}N layer 401b is lower than the refractive index of the p-Al_{0.70}In_{0.30}N layer 401a, the light confinement effect in the in-plane direction of the substrate can be obtained.

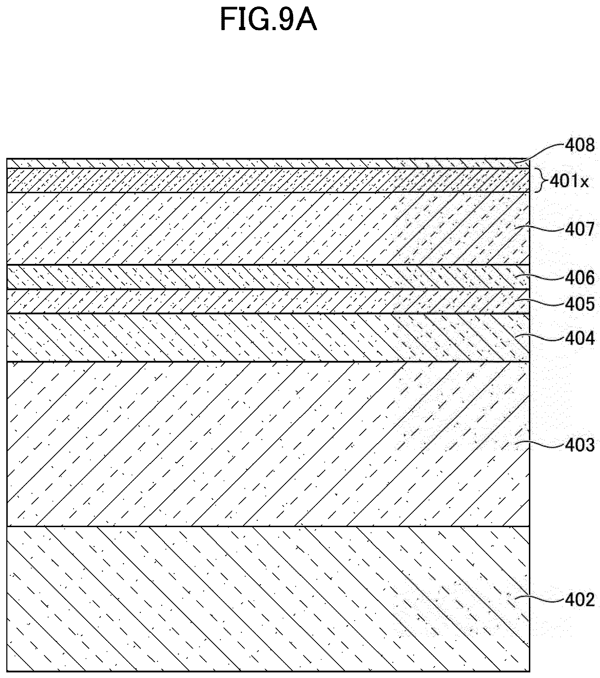

Next, a method of manufacturing the surface light emitting laser 450 according to the fourth embodiment will be described. FIGS. 9A to 9D are cross-sectional views illustrating a method of manufacturing the surface light emitting laser 450 according to the fourth embodiment. In this manufacturing method, nitride semiconductor layers included in the laser structure 400 are epitaxially grown on the n-GaN substrate 402.

First, as illustrated in FIG. 9A, the lower multilayer film reflector 403, the n-GaN layer 404, the multi quantum well layer 405, the p-Al_{0.20}Ga_{0.80}N layer 406, the p-GaN layer 407, the p-Al_{0.70}In_{0.30}N layer 401x, and the p⁺⁺-GaN layer 408 are sequentially formed on the n-GaN substrate 402 using an MOCVD device.

Mg in the p-Al_{0.20}Ga_{0.80}N layer 406, the p-GaN layer 407, the p-Al_{0.70}In_{0.30}N layer 401x, and the p⁺⁺-GaN layer 408 (hereinafter collectively referred to as p-type layers) is doped at 1×10²⁰cm⁻³ in the p⁺⁺-GaN layer 408 and doped at 2×10¹⁹cm⁻³ in the other layers.

In the p-type layer, hydrogen atoms derived from ammonia gas used for film formation in the MOCVD device are taken into the p-type layer at the same concentration as Mg in the p-type layer, thereby the Mg are inactivated (inactivation rate: 1.0). Therefore, as the first heat treatment, the structure illustrated in FIG. 9A is put in a heat treatment apparatus and the structure is heated at a temperature of 600°C in an oxidizing atmosphere. The heat treatment time is, for example, 10 minutes. Depending on the temperature and time of the heat treatment and the atmosphere gas, 90% of hydrogen atoms are desorbed from the p-type layer (inactivation rate: 0.10) by the heat treatment, and the p-type layer exhibits p-type conductivity.

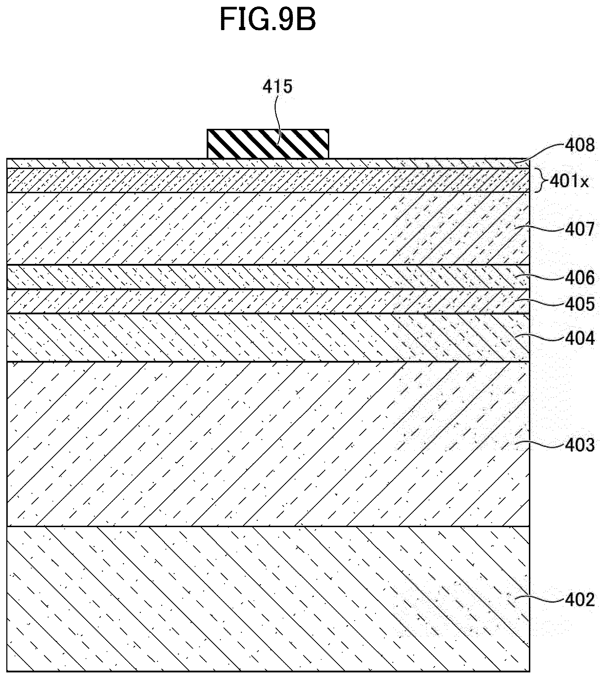

Next, the structure illustrated in FIG. 9A is taken out of the MOCVD device, and as illustrated in FIG. 9B, a SiO₂ film 415 having a diameter of 10 µm and a thickness of 100 nm is formed on the p⁺⁺-GaN layer 408 as a protective mask covering a region where the pAl_{0.70}In_{0.30}N layer 401a is to be formed. The SiO₂ film 415 can be formed by, for example, photolithography.

Thereafter, the structure illustrated in FIG. 9B is put into the MOCVD device, and a heat treatment is performed at a temperature of 800°C in a hydrogen-ammonia mixture gas atmosphere. The time of the heat treatment is, for example, 30 minutes. By this heat treatment, hydrogen atoms permeate into the portion of the p-Al_{0.70}In_{0.30}N layer 401x exposed from the SiO₂ film 415, thereby In is evaporated from this portion.

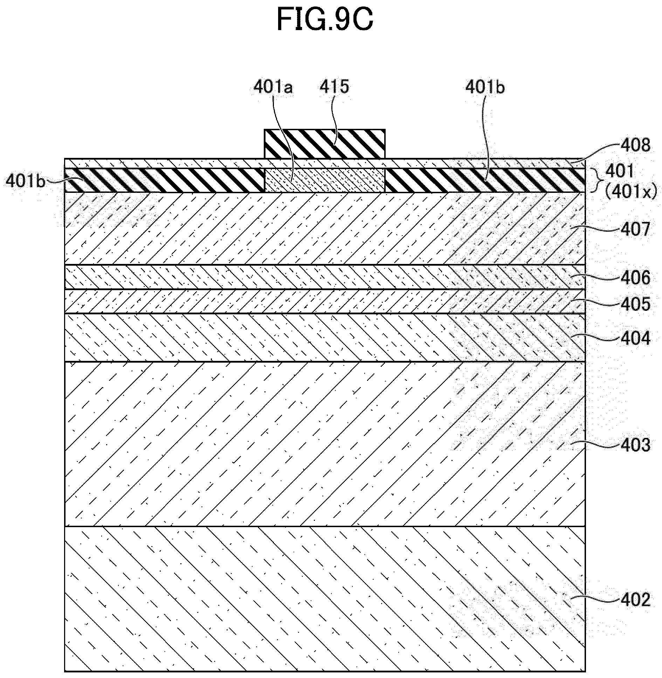

As a result, as illustrated in FIG. 9C, the portion of the p-Al_{0.70}In_{0.30}N layer 401x exposed from the SiO₂ film 415 is changed to a p-Al_{0.90}In_{0.10}N layer 401b. The remaining portion of the p-Al_{0.70}In_{0.30}N layer 401x becomes a p-Al_{0.70}In_{0.30}N layer 401a whose In composition has not changed from the In composition of the p-Al_{0.70}In_{0.30}N layer 401x. In this way, the current blocking layer 401 having the p-Al_{0.70}In_{0.30}N layer 401a and the pAl_{0.90}In_{0.10}N layer 401b is formed. Further, hydrogen having the same concentration as Mg of the p-type layer in the region where the SiO₂ film 415 is not formed is taken into the p-type layer in the region where the SiO₂ film 415 is not formed, and Mg is inactivated, thereby forming a resistance distribution in the p-type layer.

Subsequently, the structure illustrated in FIG. 9C is taken out from the MOCVD device, and the SiO₂ film 415 is removed from the structure. The SiO₂ film 415 can be removed by using, for example, buffered hydrofluoric acid. Then, the p⁺⁺-GaN layer 408, the current blocking layer 401, the p-GaN layer 407, the p-Al_{0.20}Ga_{0.80}N layer 406, the multi quantum well 405, and a part of the n-GaN layer 404 are removed by lithography and dry etching to form a mesa structure 409 for an isolation groove.

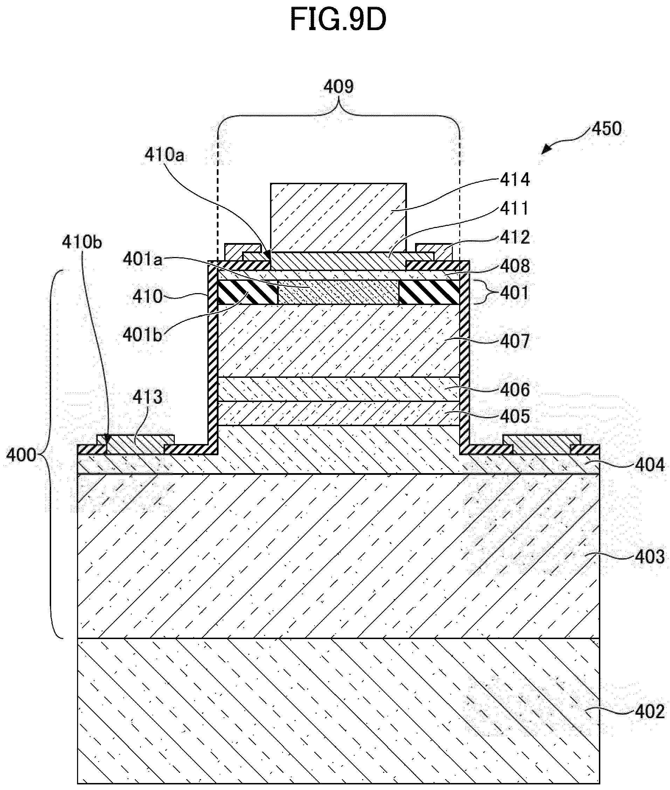

Thereafter, as illustrated in FIG. 9D, an ITO film 411 is formed on the surface of the p⁺⁺-GaN layer 408 so as to rise on the SiN film 410 through the opening 410a, and an upper electrode 412 having a ring-like planar shape is formed on the SiN film 410 and the ITO film 411 at the upper portion of the mesa structure 409. Further, the lower electrodes 413 are formed on the surface of the n-GaN layer 404 so as to rise on the SiN film 410 through the opening 410b. In the formation of the upper electrode 412, for example, a Ti film and an Au film are laminated in this order from the side where the SiN film 410 and the ITO film 411 are provided. In the formation of the lower electrodes 413, for example, a Ti film and an Al film are laminated in this order from the side where the n-GaN layer 404 is provided. Subsequently, a DBR 414 is formed on the ITO film 411 inside the upper electrodes 412.

In this way, the surface light emitting laser 450 according to the fourth embodiment can be manufactured. According to this method, an in-plane band gap distribution and an in-plane hydrogen atom concentration distribution based on the difference of the In compositions are obtained in the p-Al_{0.70}In_{0.30}N layer 401x. In other words, an electrical resistance distribution is formed due to the difference in the inactivation rate of Mg. In addition, an electric resistance distribution is generated due to the difference in the inactivation rate of Mg in the respective planes of the p-GaN layer 407 and the p⁺⁺-GaN layer 408, and thus very stable characteristics of the current blocking structure can be obtained. Further, since the refractive index distribution is formed in the plane of the current blocking layer 401, the confinement of light in the in-plane direction is enhanced, and a surface light emitting laser having good characteristics can be obtained.

### (Fifth Embodiment)

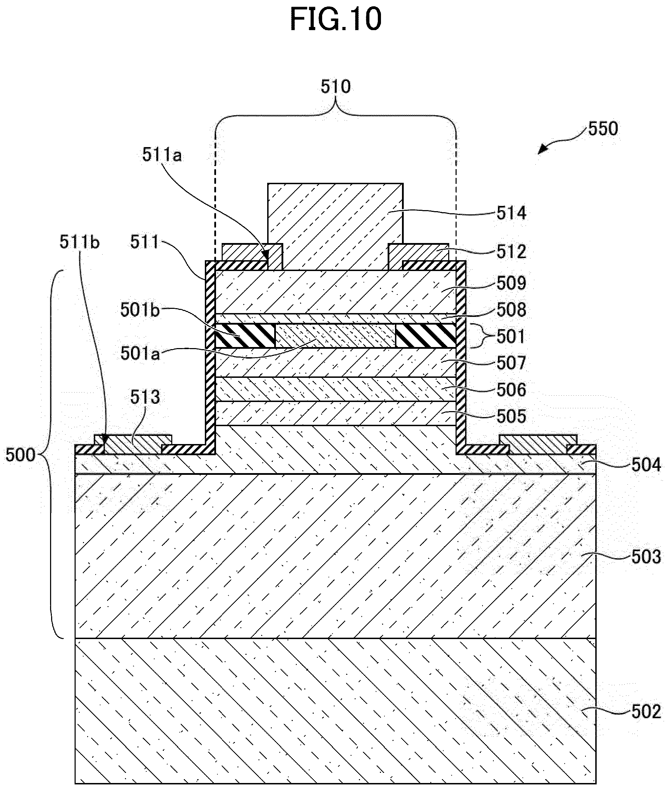

Next, a fifth embodiment will be described. The fifth embodiment relates to a surface light emitting laser including a nitride semiconductor structure. The surface light emitting laser is an example of a light emitting element. FIG. 10 is a cross-sectional view illustrating a surface light emitting laser according to a fifth embodiment.

As illustrated in FIG. 10, a surface light emitting laser 550 according to the fifth embodiment includes an n-GaN substrate 502 and a laser structure 500 on the n-GaN substrate 502. The laser structure 500 includes a lower multilayer film reflector 503, an n-GaN layer 504, a multi quantum well layer 505, a p-AlGaN layer 506, a p-GaN layer 507, a current blocking layer 501, an n⁺⁺-GaN layer 508, and an n-GaN layer 509. The current blocking layer 501 and the n⁺⁺-GaN layer 508 form a tunnel junction. The p-GaN layer 507 is an example of a p-type semiconductor layer, and the current blocking layer 501 is an example of a nitride semiconductor layer containing Mg as an impurity. The laser structure 500 is an example of a nitride semiconductor structure.

The lower multilayer film reflector 503 is formed on the n-GaN substrate 502. The lower multilayer film reflector 503 has a structure in which a high refractive index layer and a low refractive index layer are alternately laminated for 46 cycles. The high refractive index layer is, for example, an In_{0.05}Ga_{0.95}N layer having a thickness of 50 nm. The low refractive index layer has, for example, a multilayer structure with two AlN layers, each of the AlN layers having a thickness of 6 nm, inserted between three GaN layers, each of the GaN layers having a thickness of 6 nm.

The n-GaN layer 504 is formed on the lower multilayer film reflector 503. The thickness of the n-GaN layer 504 is, for example, 1.1 µm.

The multi quantum well layer 505 is formed on the n-GaN layer 504. The multi quantum well layer 505 has a structure in which an In_{0.10}Ga_{0.90}N layer having a thickness of 4 nm and a GaN layer having a thickness of 6 nm are alternately laminated for 5 cycles. The multi quantum well layer 505 is an example of an active layer.

The p-AlGaN layer 506 is formed on the multi quantum well layer 505. The thickness of the p-AlGaN layer 506 is, for example, 20 nm.

The p-GaN layer 507 is formed on the p-AlGaN layer 506. The thickness of the p-GaN layer 507 is, for example, 100 nm.

The current blocking layer 501 is formed on the p-GaN layer 507. The thickness of the current blocking layer 501 is, for example, 10 nm. The current blocking layer 501 includes a p⁺⁺-Al_{0.70}In_{0.30}N layer 501a and a p⁺⁺-Al_{0.90}In_{0.10}N layer 501b which surrounds the p⁺⁺-Al_{0.70}In_{0.30}N layer 501a in a plane parallel to the current blocking layer 501.

As described above, the In composition of the p⁺⁺-Al_{0.90}In_{0.10}N layer 501b is less than the In composition of the p⁺⁺-Al_{0.70}In_{0.30}N layer 501a. The p⁺⁺-Al_{0.70}In_{0.30}N layer 501a is an example of a first region, and the p⁺⁺-Al_{0.90}In_{0.10}N layer 501b is an example of a second region. The p⁺⁺-Al_{0.70}In_{0.30}N layer 501a and the p⁺⁺-Al_{0.90}In_{0.10}N layer 501b are doped with Mg as acceptors at a concentration of 1×10²⁰ cm⁻³.

The n⁺⁺-GaN layer 508 is formed on the current blocking layer 501. The thickness of the n⁺⁺-GaN layer 508 is, for example, 10 nm. The n⁺⁺-GaN layer 508 is doped with Si as a donor at a concentration of 3×10²⁰ cm⁻³.

A tunnel junction is formed by the current blocking layer 501 highly doped with Mg and the n-GaN layer 508 highly doped with Si. The n-GaN layer 509 is formed on the n⁺⁺-GaN layer 508. The thickness of the n-GaN layer 509 is, for example, 440 nm.

In the laser structure 500, the n-GaN layer 509, the n⁺⁺-GaN layer 508, the current blocking layer 501, the p-GaN layer 507, the p-AlGaN layer 506, the multi quantum well layer 505, and a part of the n-GaN layer 504 are etched, and a mesa structure 510 having a circular planar shape is formed, for example.

A SiN film 511 is formed as a passivation film so as to cover the surface and the side surface of the mesa structure 510 and the surface of the n-GaN layer 504. The SiN film 511 has an opening 511a exposing a part of the n-GaN layer 508 and an opening 511b exposing a part of the n-GaN layer 504. For example, the p⁺⁺-Al_{0.70}In_{0.30}N layer 501a is located inside the opening 511a in a plan view.

A ring-shaped upper electrode 512 is formed on the surface of the n-GaN layer 509 except for the central portion of the opening 511a so as to rise on the SiN film 511 through the opening 511a. Inside the upper electrodes 512, a dielectric DBR 514 is formed on the n-GaN layer 509. Lower electrodes 513 are formed on the surface of the n-GaN layer 504 so as to rise on the SiN film 511 through the opening 511b. The upper electrode 512 and the lower electrodes 513 include, for example, a Ti film and an Al film laminated in order from the side where the n-GaN layer 504 and the n-GaN layer 509 are provided. The DBR 514 includes, for example, a tantalum oxide film (Ta₂O₅ film) and a SiO₂ film. The lower multilayer film reflector 503 and the DBR 514 constitute a resonator structure.

In the surface light emitting laser 550, as described above, the current blocking layer 501 includes the p⁺⁺-Al_{0.70}In_{0.30}N layer 501a and the p⁺⁺-Al_{0.90}In_{0.10}N layer 501b. The band gap of the p⁺⁺-Al_{0.70}In_{0.30}N layer 501a is 3.59 eV, and the band gap of the p⁺⁺-Al_{0.90}In_{0.10}N layer 501b is 5.24 eV. The band gap of the p-GaN layer 507 and the n⁺⁺-GaN layer 508 sandwiching the current blocking layer 501 is 3.4 eV. As described above, the band gap of the p⁺⁺-Al_{0.90}In_{0.10}N layer 501b is larger than the band gap of any of the p⁺⁺-Al_{0.70}In_{0.30}N layer 501a, the p-GaN layer 507, and the n⁺⁺-GaN layer 508 existing therearound by 1.0 ev or more. Therefore, a large band offset is formed between the p⁺⁺-Al_{0.90}In_{0.10}N layer 501b and the p⁺⁺-Al_{0.70}In_{0.30}N layer 501a, the p-GaN layer 507, and the n⁺⁺-GaN layer 508.

Further, by a manufacturing method described later, among the planes of the p⁺⁺-Al_{0.90}In_{0.10}N layer 501b, the p⁺⁺-Al_{0.70}In_{0.30}N layer 501a, and the p-GaN layer 507, the concentration of hydrogen atoms in the region where the p⁺⁺-Al_{0.90}In_{0.10}N layer 501b is formed is higher than the concentration of hydrogen atoms in the region where the p⁺⁺-Al_{0.70}In_{0.30}N layer 501a is formed between the planes of the p⁺⁺-Al_{0.70}In_{0.30}N layer 501a and the p-GaN layer 507.

Therefore, in the current blocking layer 501, the current is blocked by the p⁺⁺-Al_{0.90}In_{0.10}N layer 501b and selectively flows through the p⁺⁺-Al_{0.70}In_{0.30}N layer 501a. In addition, since the refractive index of the p⁺⁺-Al_{0.90}In_{0.10}N layer 501b is lower than the refractive index of the p⁺⁺-Al_{0.70}In_{0.30}N layer 501a, the light confinement effect in the in-plane direction can be obtained.

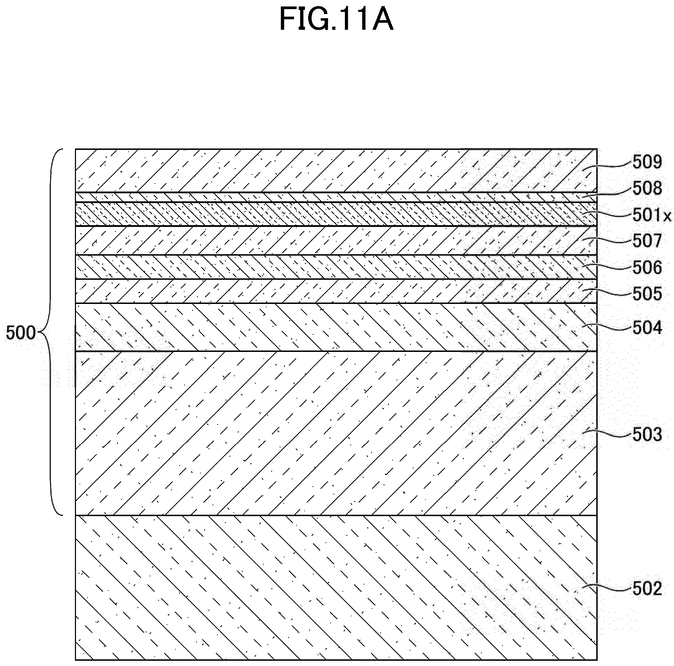

Next, a method of manufacturing the surface light emitting laser 550 according to the fifth embodiment will be described. FIGS. 11A to 11D are cross-sectional views illustrating a method of manufacturing the surface light emitting laser 550 according to the fifth embodiment. In this manufacturing method, nitride semiconductor layers included in the laser structure 500 are epitaxially grown on an n-GaN substrate 502.

First, as illustrated in FIG. 11A, the lower multilayer film reflector 503, the n-GaN layer 504, the multi quantum well layer 505, the p-AlGaN layer 506, the p-GaN layer 507, the p⁺⁺-Al_{0.70}In_{0.30}N layer 501x, the n⁺⁺-GaN layer 508, and the n-GaN layer 509 are sequentially formed on the n-GaN substrate 502 using an MOCVD device.

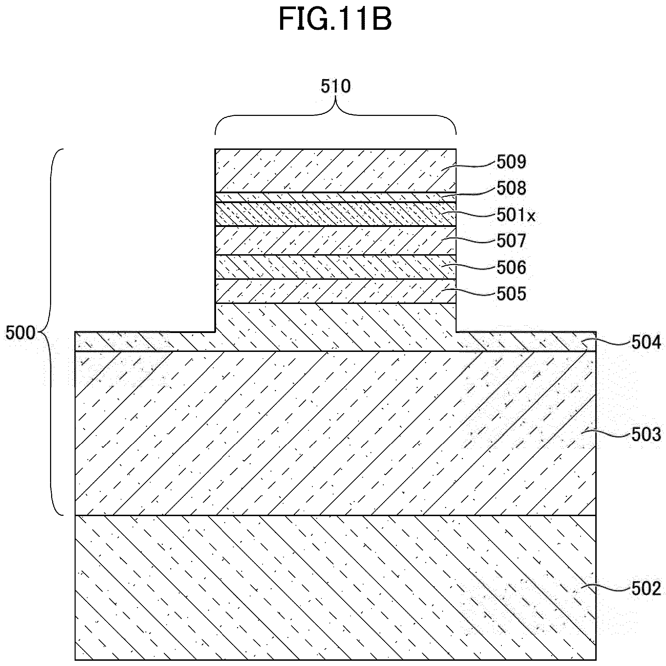

Next, the structure illustrated in FIG. 11A is taken out of the MOCVD device, and as illustrated in FIG. 11B, the n-GaN layer 509, the n⁺⁺-GaN layer 508, the p⁺⁺-Al_{0.70}In_{0.30}N layer 501x, the p-GaN layer 507, the p-AlGaN layer 506, the multi quantum well layer 505, and a part of the n-GaN layer 504 are removed by lithography and dry etching to form a mesa structure 510.

Thereafter, the structure illustrated in FIG. 11B is subjected to heat treatment at 800°C in an oxidizing atmosphere as first heat treatment. The time of the heat treatment is, for example, 30 minutes. By this heat treatment, 90% of hydrogen atoms bonded to Mg in the p-AlGaN layer 506, the p-GaN layer 507, and the p⁺⁺-Al_{0.70}In_{0.30}N layer 501x are desorbed from the sidewall of the mesa structure 510 (inactivation rate is 0.10). As a result, Mg is activated, and p-type conduction is exhibited.

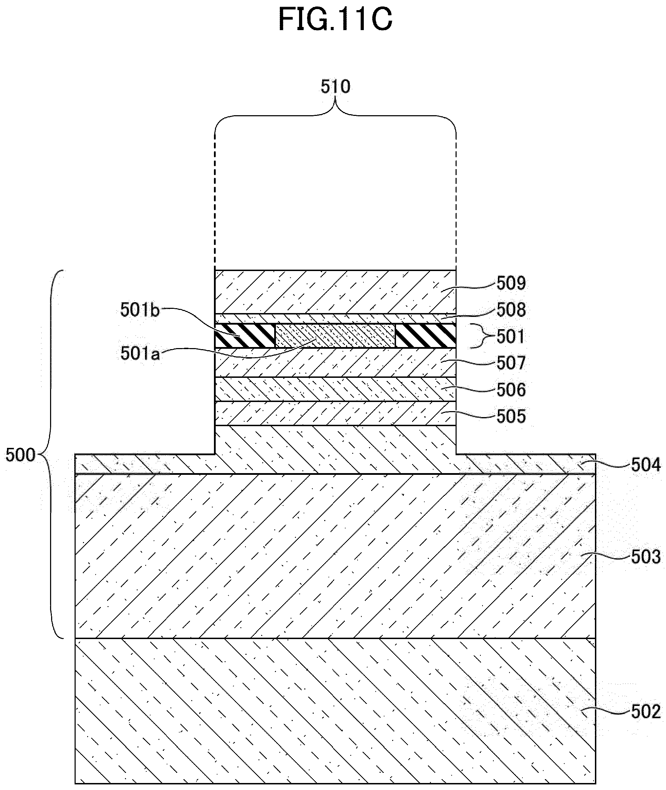

Next, the structure illustrated in FIG. 11B is put in an MOCVD device, and heat treatment is performed at a temperature of 800°C in a hydrogen-ammonia mixture gas atmosphere. The time of the heat treatment is, for example, 30 minutes. By this heat treatment, hydrogen atoms permeate from the sidewall of the mesa structure 510 into the p⁺⁺-Al_{0.70}In_{0.30}N layer 501x, thereby In is evaporated from this portion. As a result, as illustrated in FIG. 11C, the sidewall of the p⁺⁺-Al_{0.70}In_{0.30}N layer 501x is changed to a p⁺⁺-Al_{0.90}In_{0.10}N layer 501b. The remaining portion of the p⁺⁺-Al_{0.70}In_{0.30}N layer 501x becomes a p⁺⁺-Al_{0.70}In_{0.30}N layer 501a whose In composition has not changed from the In composition of the p⁺⁺-Al_{0.70}In_{0.30}N layer 501x. In this way, the current blocking layer 501 having the p⁺⁺-Al_{0.70}In_{0.30}N layer 501a and the p⁺⁺-Al_{0.90}In_{0.10}N layer 501b is formed.

The area where the p⁺⁺-Al_{0.90}In_{0.10}N layer 501b is formed is, for example, within about 10 µm from the sidewall. Further, the hydrogen atoms also penetrate into the p-AlGaN layer 506 and the p-GaN layer 507 from the sidewalls, and Mg are inactivated. Hydrogen atoms having the same concentration as Mg in the p-type layer on the sidewall are taken in (inactivation rate: 1.0), and Mg is inactivated, whereby an electrical resistance distribution is formed in the p-type layer.

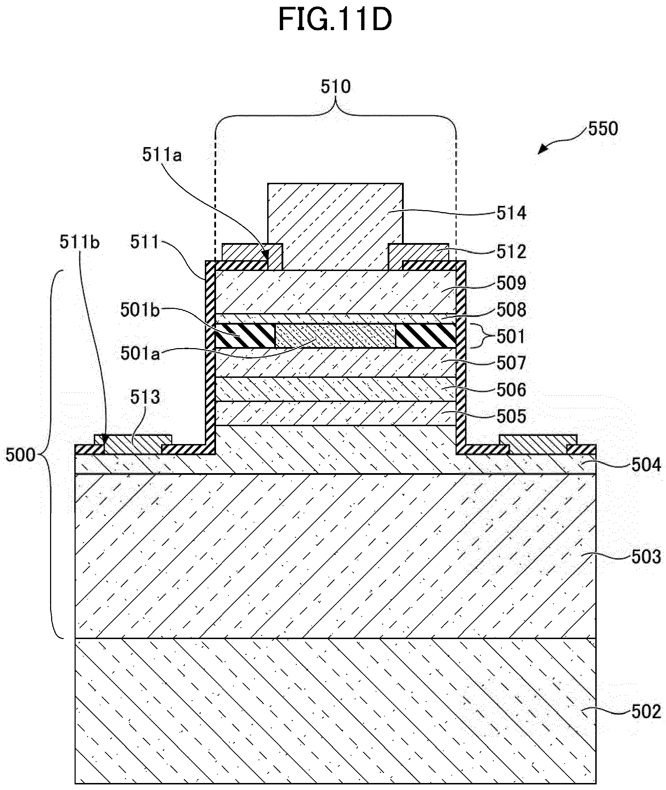

Subsequently, as illustrated in FIG. 11D, a SiN film 511 is formed so as to cover the front and side surfaces of the mesa structure 510 and the front surface of the n-GaN layers 504. Next, an opening 511a that exposes a portion of the surface of n-GaN layer 509 and an opening 511b that exposes a portion of the surface of n-GaN layer 504 are formed in the SiN film 511.

Thereafter, a ring-shaped upper electrode 512 is formed on the surface of n-GaN layer 509 except for the center of the opening 511a so as to rise on the SiN film 511. Further, the lower electrodes 513 are formed on the n-GaN layer 504 so as to rise on the SiN film 511 through the opening 511b. In the formation of the upper electrode 512, for example, a Ti film and an Al film are laminated in this order from the n-GaN layer 509, and in the formation of the lower electrodes 513, for example, a Ti film and an Al film are laminated in this order from the n-GaN layer 504. Subsequently, a DBR 514 is formed inside the upper electrode 512.

In this way, the surface light emitting laser 550 according to the fifth embodiment can be manufactured. The composition, conductivity type, and impurity concentration of the current blocking layer are not limited to those of these embodiments. The application of the nitride semiconductor structure including the current blocking layer is not limited to the optical element, and the nitride semiconductor structure including the current blocking layer can be used for other electronic devices.

### (Sixth Embodiment)

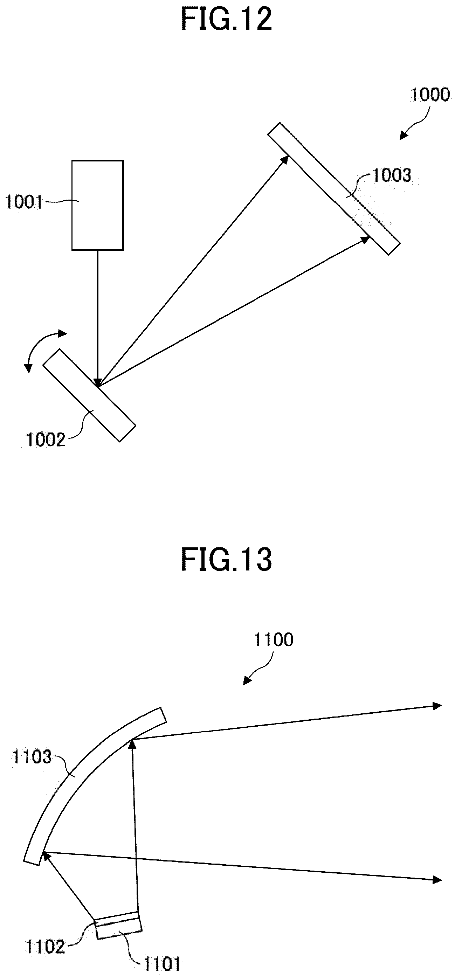

Next, a sixth embodiment will be described. The sixth embodiment relates to a projection device that draws an image by scanning a laser. The projection device is an example of a light source device. FIG. 12 is a diagram illustrating a layout of the projection device according to the sixth embodiment.

A projection device 1000 according to the sixth embodiment includes a light source 1001 and an optical scanning unit 1002. The light source 1001 includes, for example, one or more of the surface light emitting laser 450 of the fourth embodiment and the surface light emitting laser 550 of the fifth embodiment. When the number of the surface light emitting lasers 450 or the surface light emitting lasers 550 is one, the projection device 1000 projects a monochrome image onto a target object 1003. When the projection device 1000 includes a plurality of surface light emitting lasers 450 and 550, the projection device 1000 can project an image of a plurality of colors onto the target object 1003 by emitting light from the emission surface of each surface light emitting laser while aligning the optical axes of the surface light emitting lasers on the same axis and changing the oscillation wavelength for each surface light emitting laser.

The optical scanning unit 1002 includes an element for scanning the laser light emitted from the light source 1001 and projecting the laser light onto the target object 1003. As such an element, a micro electro mechanical systems (MEMS) mirror that moves in two axes or an element that combines two MEMS mirrors that move in one axis can be used. The optical scanning unit 1002 is an example of an optical element that adjusts the traveling direction of the laser light emitted from the light source 1001.

When an image is generated, the intensity of the laser light is modulated in accordance with the scanning of the optical scanning unit 1002, and the laser light is irradiated onto the target object 1003. In this way, an image can be generated directly on the target object 1003.

In the case where a single or a small number of surface light emitting lasers are used as the light source 1001, laser light on the order of µW to several mW is output, and an image can be drawn in a minute region. The projection device 1000 can be used as, for example, a retinal display.

When a two-dimensional array light source in which a large number of surface light emitting lasers are arrayed is used as the light source 1001, laser light on the order of mW to kW can be output to draw an image in a large area. Such a projection device can be used as, for example, a projector.

### (Seventh Embodiment)

Next, a seventh embodiment will be described. The seventh embodiment relates to a light projection device. The light projection device is an example of a light source device. FIG. 13 is a view illustrating a layout of the light projection device of the seventh embodiment.

The light projection device 1100 according to the seventh embodiment includes a light source 1101, a fluorescent member 1102, and a light projection member 1103. As the light source 1101, for example, a two-dimensional array light source in which a plurality of the surface light emitting lasers 450 according to the fourth embodiment and the surface light emitting lasers 550 according to the fifth embodiment are arrayed is used, and the fluorescent member 1102 is excited by the light emitted from the light source 1101. Light emitted from the light source 1101 and light emitted by excitation of the fluorescent member 1102 are spread two dimensionally and projected by the light projecting member 1103. FIG. 13 illustrates a reflecting mirror as an example of the light projecting member 1103.

As the fluorescent member 1102, for example, a fluorescent member that emits yellow light is used when the light emitted from the light source 1101 is blue light, and a fluorescent member that emits white light is used when the light emitted from the light source 1101 is ultraviolet light. The fluorescent member 1102 is an example of an optical element that adjusts the wavelength of the laser light emitted from the light source 1101. The light projecting member 1103 is an example of an optical element that adjusts the traveling direction of the laser light emitted from the light source 1101 and having the wavelength adjusted by the fluorescent member 1102.

The light source 1101 is, for example, a two-dimensional array light source in which several thousands to several tens of thousands of surface light emitting lasers are arranged in a two-dimensional array in a plane, and electrodes are connected to the light source so that a plurality of surface light emitting laser groups can be individually driven. The surface light emitting laser group may include a plurality of surface light emitting lasers or a single surface light emitting laser.

By selecting a group of surface light emitting lasers to which a voltage is applied, light can be projected to a place or space as desired by one light source 1101. For example, when the light projection device 1100 is used as a headlight module for a vehicle, the light projection device 1100 can be used as a variable light distribution type headlight.

### (Eighth Embodiment)

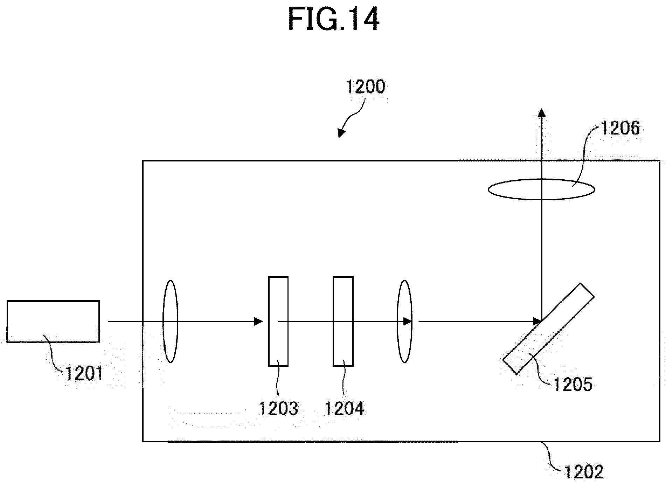

Next, an eighth embodiment will be described. The eighth embodiment relates to a projection device. The projection device is an example of a light source device. FIG. 14 is a view illustrating a layout of a projection device according to the eighth embodiment.

The projection device 1200 according to the eighth embodiment includes a light source 1201 and a projection optical unit 1202. The light source 1201 includes a two-dimensional array light source in which a plurality of the surface light emitting lasers 450 according to the fourth embodiment and the surface light emitting lasers 550 according to the fifth embodiment are arrayed.

The projection optical unit 1202 includes at least a fluorescent member 1203, a filter 1204, and an image generation element 1205, and may further include a lens such as a projection lens 1206, a mirror, and the like as necessary.

The fluorescent member 1203 is excited by a part of the light incident on the projection optical unit 1202 from the light source 1201 to produce white light. As the fluorescent member 1203, for example, the fluorescent member that emits yellow light is used when the light emitted from the light source 1201 is blue light, and the fluorescent member that emits white light is used when the light emitted from the light source 1201 is ultraviolet light.

The filter 1204 is a filter that separates colors from white light, and also includes a movable portion. As the filter 1204, for example, a color wheel or the like that transmits red, blue, and green light is used.

The image generation element 1205 is an element that generates an image from the light transmitted through the filter 1204. As the image generation element 1205, for example, MEMS devices with microscopic mirrors in two-dimensional arrays, reflective liquid crystal devices, and the like are used.

The projection lens 1206 enlarges the image generated by the image generation element 1205 to a desired magnification and projects the image onto the target object. The projection optical unit 1202 is an example of an optical element that adjusts the wavelength, the traveling direction, and the like of the laser light emitted from the light source 1201.

In the present embodiment, the projection optical unit 1202 includes the filter 1204, but a prism or a dichroic mirror may be used instead of the filter 1204. When the prism or the dichroic mirror is used, a configuration in which light is separated into, for example, red, green, and blue, images of the respective colors are generated by three image generation elements, and finally the images that are combined by the prism or the like can be employed.

### (Ninth Embodiment)

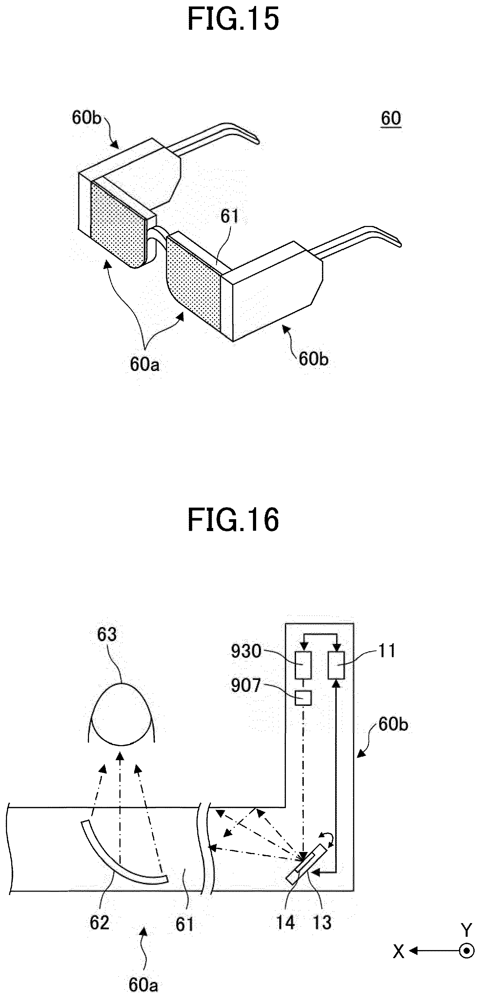

Next, a head mounted display according to a ninth embodiment will be described with reference to FIGS. 15 and 16. FIG. 15 is a perspective view illustrating an example of the configuration of the head mounted display 60 according to the embodiment. FIG. 16 is a cross-sectional view illustrating an example of the configuration of a head-mounted display 60.

The head-mounted display 60 is an example of a head mounted display device that can be mounted on the head of a person, and can have a shape similar to that of glasses, for example. Hereinafter, the head mount display is abbreviated as HMD.

In FIG. 15, the HMD 60 is constituted by a front 60a and a temple 60b which are provided in a pair on the left and right sides substantially symmetrically. The front 60a can be formed of, for example, a light guide plate 61, and an optical system, a control unit, and the like can be incorporated in the temple 60b.

FIG. 16 partially illustrates the configuration of the HMD 60. Although FIG. 15 illustrates the configuration for the left eye, the HMD 60 has the same configuration for the right eye.

The HMD 60 includes a control device 11, a light source unit 930, a light amount adjustment unit 907, a movable device 13 having a reflection surface 14, a light guide plate 61, and a half mirror 62. The HMD 60 is an example of a display device.

The light source unit 930 is a unit in which a red laser light source, a green laser light source, a blue laser light source, a plurality of collimator lenses, and a plurality of dichroic mirrors are unitized by an optical housing. In the light source unit 930, the laser light of three colors from the red laser light source, the green laser light source, and the blue laser light source are combined by a dichroic mirror serving as a combining unit. The light source unit 930 emits the combined parallel light. The light source unit 930 is an example of a light source device.

Each laser light source includes, for example, one or more of the surface light emitting lasers 450 according to the fourth embodiment and the surface light emitting lasers 550 according to the fifth embodiment, and emits laser light. Although the oscillation wavelength is specified in the fourth and fifth embodiments, the oscillation wavelength can be changed by selecting the material and optical thickness of the semiconductor layer.

The light from the light source unit 930 is adjusted in light amount by a light amount adjustment unit 907, then enters the movable device 13. The movable device 13 moves the reflection surface 14 in the XY directions based on a signal from the control device 11, and the light from the light source unit 930 is two-dimensionally scanned. The driving control of the movable device 13 is performed in synchronization with the light emission timing of the red laser light source, the green laser light source, and the blue laser light source.

The scanning light from the movable device 13 enters the light guide plate 61. The light guide plate 61 guides the scanning light to the half mirror 62 while reflecting the scanning light on the inner wall surface. The light guide plate 61 is formed of a resin or the like having transparency to the wavelength of the scanning light.

The half mirror 62 reflects the light from the light guide plate 61 to the back side of the HMD 60, and emits the light in the direction of the eyes of the wearer 63 of the HMD 60. The half mirror 62 has, for example, a free-form surface shape. The image formed by the scanning light is reflected by the half mirror 62 and is formed on the retina of the wearer 63. Alternatively, the image is formed on the retina of the wearer 63 by the reflection by the half mirror 62 and the lens effect of the crystalline lens in the eyeball. Further, the spatial distortion of the image is corrected by the reflection at the half mirror 62. The wearer 63 can visually recognize an image formed by the light scanned in the XY directions.

Since the half mirror 62 is used, the wearer 63 visually recognizes an image formed by the light from the outside world and an image formed by the scanning light in a superimposed manner. A mirror may be provided instead of the half mirror 62 to eliminate light from the outside world and to allow only an image formed by the scanning light to be visually recognized.

In the present embodiment, as compared with the case where an edge light emitting laser is used as a light source, the number of components such as an ND filter is reduced, and a small and lightweight HMD with low power consumption can be realized.

### (Tenth Embodiment)

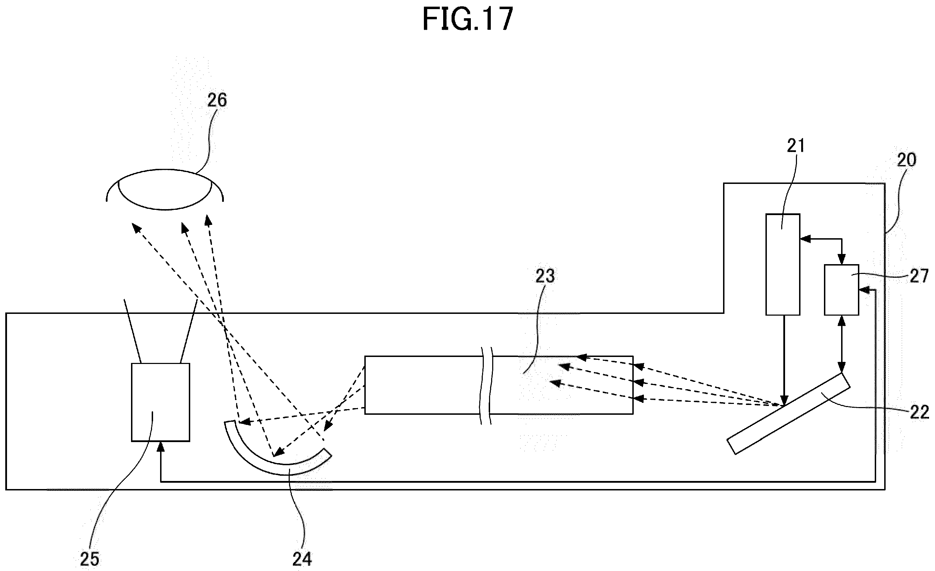

Next, a biometric authentication device using a pupillary response of a person according to a tenth embodiment will be described with reference to FIG. 17. FIG. 17 is a view for explaining an example of the configuration of the biometric authentication device according to the present embodiment. A biometric authentication device 20 includes a light source 21, a light scanning unit 22, a first optical device 23, a second optical device 24, an image sensor 25, and a control device 27. The light source 21 includes, for example, one or more of the surface light emitting laser 450 according to the fourth embodiment or of the surface light emitting laser 550 according to the fifth embodiment, and light emitted from the light source 21 is incident on the optical scanning unit 22. The optical scanning unit 22 moves the reflection surface based on a signal from the control device 27 and scans the light from the light source 21. The scanning light from the optical scanning unit 22 is irradiated to the pupil 26 via the first optical element 23 and the second optical element 24. The size of the pupil is controlled by the intensity of the light irradiated to the pupil 26, and iris information is acquired by the imaging element 25. Then, the control device 27 acquires information of the pupil 26 of the person (living body) based on the output of the imaging element 25. The biometric authentication device 20 is an example of a biometric information obtaining device, the light source 21 is an example of a light source device, the imaging element 25 is an example of a light receiving device, and the control device 27 is an example of an information obtaining unit.

For example, the first optical element 23 is a waveguide that guides the light scanned by the light scanning unit 22 to the second optical element 24, and the second optical element 24 is a mirror for changing the path of the light emitted from the first optical element 23 to the pupil 26. Although the present embodiment describes the two optical elements separately, other methods can be used as long as the optical elements emit the scanned light to the pupil 26.

The light source 21 can include a plurality of elements, and is, for example, a module mounted so that lasers of four wavelengths of red, blue, green, and infrared are emitted on the same axis. Since the pupil response is more sensitive to the blue and green wavelengths than to other wavelengths, fine iris information narrower than the pupil can be obtained. Further, by using multiple wavelengths, biometric information of irises for respective wavelengths can be obtained, and the authentication accuracy is further improved.

For example, by using the surface light emitting laser 450 according to the fourth embodiment or the surface light emitting laser 550 according to the fifth embodiment, the biometric authentication device 20 with high accuracy can be realized.

Although the preferred embodiments and the like have been described in detail above, the present invention is not limited to the above-described embodiments and the like, and various modifications and substitutions can be made to the above-described embodiments and the like without departing from the scope described in the claims.

This application claims priority under Japanese Patent Application No. 2023-045313, filed March 22, 2023.

## Claims

1. A nitride semiconductor structure comprising:
a nitride semiconductor layer (101, 105, 301, 401, 501) containing Mg as an impurity, the nitride semiconductor layer including a first region (101a, 301a, 401a, 501a) and a second region (101b, 301b, 401b, 501b) surrounding the first region in a plane parallel to the nitride semiconductor layer,
wherein an In composition of the second region is less than an In composition of the first region, and
wherein a hydrogen atom concentration of the second region is higher than a hydrogen atom concentration of the first region by two times or more.

2. The nitride semiconductor structure according to claim 1, wherein a Mg inactivation rate of the second region is 0.5 or more.

3. The nitride semiconductor structure according to claim 1,
wherein the first region includes AlInN or AlGaInN, and
wherein Mg as an impurity is included in the AlInN or the AlGaInN.

4. The nitride semiconductor structure according to any one of claims 1 to 3, further comprising a lower semiconductor layer (105a, 306a, 407) located on one side of the second region and an upper semiconductor layer (105b, 306b, 408) located on the other side of the second region.

5. The nitride semiconductor structure according to claim 4, wherein the film thickness of the upper semiconductor layer is 100 nm or less.

6. The nitride semiconductor structure according to any one of claims 1 to 5, further comprising a p-type semiconductor layer (507) located on one side of the second region and an n-type semiconductor layer (508) located on the other side of the second region.

7. A light emitting element comprising the nitride semiconductor structure according to any one of claims 1 to 6,
wherein the nitride semiconductor structure further includes an active layer (102, 304, 405, 505).

8. The light-emitting element according to claim 7, wherein the nitride semiconductor structure is formed on a substrate (103, 302, 402, 502),
and the active layer is disposed on the substrate of the nitride semiconductor layer.

9. The light emitting element according to claim 7 or 8, further comprising a resonator structure configured to resonate light emitted from the active layer.

10. The light-emitting element according to claim 9, wherein the resonator structure further includes a first reflector (403, 503) disposed on one side of the active layer and a second reflector (414, 514) disposed on the other side of the active layer, and the nitride semiconductor structure includes the first reflector.

11. The light-emitting element according to claim 10, wherein the second reflector is a dielectric distributed Bragg reflector.

12. The light-emitting element according to claim 10 or 11, further comprising an ITO film (411) located between the second region and the second reflector.

13. A light source device comprising the light emitting element according to any one of claims 7 to 12.

14. A method of manufacturing a nitride semiconductor structure comprising:
forming a nitride semiconductor layer containing Mg as an impurity;
heating the nitride semiconductor layer by performing a first heat treatment in an inert gas atmosphere to activate the Mg in the nitride semiconductor layer; and
performing a hydrogen penetration treatment forming a first region and a second region which surrounds the first region in a plane parallel to the nitride semiconductor layer and blocks a current flow in the nitride semiconductor layer, by incorporating hydrogen atoms into the nitride semiconductor layer,
wherein the hydrogen penetration treatment is performed after the first heat treatment,
wherein an In composition of the second region is less than an In composition of the first region, and
wherein a hydrogen atom concentration of the second region is higher than a hydrogen atom concentration of the first region by two times or more.

## Patentansprüche

1. Nitridhalbleiterstruktur, umfassend:
eine Nitridhalbleiterschicht (101, 105, 301, 401, 501), die Mg als eine Verunreinigung enthält, wobei die Nitridhalbleiterschicht einen ersten Bereich (101a, 301a, 401a, 501a) und einen zweiten Bereich (101b, 301b, 401b, 501b) beinhaltet, der den ersten Bereich in einer Ebene parallel zu der Nitridhalbleiterschicht umgibt,
wobei eine In-Zusammensetzung des zweiten Bereichs geringer ist als eine In-Zusammensetzung des ersten Bereichs, und
wobei eine Wasserstoffatomkonzentration des zweiten Bereichs um das Zweifache oder mehr höher ist als eine Wasserstoffatomkonzentration des ersten Bereichs.

2. Nitridhalbleiterstruktur nach Anspruch 1, wobei eine Mg-Inaktivierungsrate des zweiten Bereichs 0,5 oder mehr beträgt.

3. Nitridhalbleiterstruktur nach Anspruch 1,
wobei der erste Bereich AlInN oder AlGaInN beinhaltet und
wobei Mg als eine Verunreinigung in dem AlInN oder dem AlGaInN beinhaltet ist.

4. Nitridhalbleiterstruktur nach einem der Ansprüche 1 bis 3, die ferner eine untere Halbleiterschicht (105a, 306a, 407), die sich auf einer Seite des zweiten Bereichs befindet, und eine obere Halbleiterschicht (105b, 306b, 408) umfasst, die sich auf der anderen Seite des zweiten Bereichs befindet.

5. Nitridhalbleiterstruktur nach Anspruch 4, wobei die Foliendicke der oberen Halbleiterschicht 100 nm oder weniger beträgt.

6. Nitridhalbleiterstruktur nach einem der Ansprüche 1 bis 5, die ferner eine p-Halbleiterschicht (507), die sich auf einer Seite des zweiten Bereichs befindet, und eine n-Halbleiterschicht (508) umfasst, die sich auf der anderen Seite des zweiten Bereichs befindet.

7. Lichtemissionselement, das die Nitridhalbleiterstruktur nach einem der Ansprüche 1 bis 6 umfasst,
wobei die Nitridhalbleiterstruktur ferner eine aktive Schicht (102, 304, 405, 505) beinhaltet.

8. Lichtemissionselement nach Anspruch 7, wobei die Nitridhalbleiterstruktur auf einem Substrat (103, 302, 402, 502) ausgebildet ist
und die aktive Schicht auf dem Substrat der Nitridhalbleiterschicht angeordnet ist.

9. Lichtemissionselement nach Anspruch 7 oder 8, das ferner eine Resonatorstruktur umfasst, die dazu konfiguriert ist, von der aktiven Schicht emittiertes Licht zu resonieren.

10. Lichtemissionselement nach Anspruch 9, wobei die Resonatorstruktur ferner einen ersten Reflektor (403, 503), der auf einer Seite der aktiven Schicht angeordnet ist, und einen zweiten Reflektor (414, 514) beinhaltet, der auf der anderen Seite der aktiven Schicht angeordnet ist, und die Nitridhalbleiterstruktur den ersten Reflektor beinhaltet.

11. Lichtemissionselement nach Anspruch 10, wobei der zweite Reflektor ein dielektrischer verteilter Bragg-Reflektor ist.

12. Lichtemissionselement nach Anspruch 10 oder 11, das ferner eine ITO-Folie (411) umfasst, die sich zwischen dem zweiten Bereich und dem zweiten Reflektor befindet.

13. Lichtquellenvorrichtung, die das Lichtemissionselement nach einem der Ansprüche 7 bis 12 umfasst.

14. Verfahren zum Fertigen einer Nitridhalbleiterstruktur, umfassend:
Ausbilden einer Nitridhalbleiterschicht, die Mg als eine Verunreinigung enthält;
Erhitzen der Nitridhalbleiterschicht durch Durchführen einer ersten Wärmebehandlung in einer Inertgasatmosphäre, um das Mg in der Nitridhalbleiterschicht zu aktivieren; und
Durchführen einer Behandlung zum Eindiffundieren von Wasserstoff, die einen ersten Bereich und einen zweiten Bereich ausbildet, der den ersten Bereich in einer zu der Nitridhalbleiterschicht parallelen Ebene umgibt und einen Stromfluss in der Nitridhalbleiterschicht blockiert, indem Wasserstoffatome in die Nitridhalbleiterschicht eingeschlossen werden,
wobei die Behandlung zum Eindiffundieren von Wasserstoff nach der ersten Wärmebehandlung durchgeführt wird,
wobei eine In-Zusammensetzung des zweiten Bereichs geringer ist als eine In-Zusammensetzung des ersten Bereichs und
wobei eine Wasserstoffatomkonzentration des zweiten Bereichs um das Zweifache oder mehr höher ist als eine Wasserstoffatomkonzentration des ersten Bereichs.

## Revendications

1. Structure semi-conductrice au nitrure comprenant :
une couche semi-conductrice au nitrure (101, 105, 301, 401, 501) contenant Mg en tant qu'impureté, la couche semi-conductrice au nitrure incluant une première région (101a, 301a, 401a, 501a) et une deuxième région (101b, 301b, 401b, 501b) entourant la première région dans un plan parallèle à la couche semi-conductrice au nitrure,
dans laquelle une composition d'In de la deuxième région est inférieure à une composition d'In de la première région, et
dans laquelle une concentration en atomes d'hydrogène de la deuxième région est plus élevée qu'une concentration en atomes d'hydrogène de la première région de deux fois ou plus.

2. Structure semi-conductrice au nitrure selon la revendication 1, dans laquelle un taux d'inactivation de Mg de la région zone est de 0,5 ou plus.

3. Structure semi-conductrice au nitrure selon la revendication 1,
dans laquelle la première région inclut AlInN ou AlGaInN, et
dans laquelle Mg en tant qu'impureté est inclus dans l'AlInN ou l'AlGaInN.

4. Structure semi-conductrice au nitrure selon l'une quelconque des revendications 1 à 3, comprenant en outre une couche semi-conductrice inférieure (105a, 306a, 407) située d'un côté de la deuxième région et une couche semi-conductrice supérieure (105b, 306b, 408) située de l'autre côté de la deuxième région.

5. Structure semi-conductrice au nitrure selon la revendication 4, dans laquelle l'épaisseur de film de la couche semi-conductrice supérieure est de 100 nm ou moins.

6. Structure semi-conductrice au nitrure selon l'une quelconque des revendications 1 à 5, comprenant en outre une couche semi-conductrice de type p (507) située d'un côté de la deuxième région et une couche semi-conductrice de type n (508) située de l'autre côté de la deuxième région.

7. Élément émetteur de lumière comprenant la structure semi-conductrice au nitrure selon l'une quelconque des revendications 1 à 6,
dans lequel la structure semi-conductrice au nitrure inclut en outre une couche active (102, 304, 405, 505).

8. Élément émetteur de lumière selon la revendication 7, dans lequel la structure semi-conductrice au nitrure est formée sur un substrat (103, 302, 402, 502),
et la couche active est disposée sur le substrat de la couche semi-conductrice au nitrure.

9. Élément émetteur de lumière selon la revendication 7 ou 8, comprenant en outre une structure de résonateur configurée pour faire résonner de la lumière émise à partir de la couche active.

10. Élément émetteur de lumière selon la revendication 9, dans lequel la structure de résonateur inclut en outre un premier réflecteur (403, 503) disposé d'un côté de la couche active et un deuxième réflecteur (414, 514) disposé de l'autre côté de la couche active, et la structure semi-conductrice au nitrure inclut le premier réflecteur.

11. Élément émetteur de lumière selon la revendication 10, dans lequel le deuxième réflecteur est un réflecteur de Bragg distribué diélectrique.

12. Élément émetteur de lumière selon la revendication 10 ou 11, comprenant en outre un film d'ITO (411) situé entre la deuxième région et le deuxième réflecteur.

13. Dispositif de source de lumière comprenant l'élément émetteur de lumière selon l'une quelconque des revendications 7 à 12.

14. Procédé de fabrication d'une structure semi-conductrice au nitrure comprenant :
la formation d'une couche semi-conductrice au nitrure contenant Mg en tant qu'impureté ;
le chauffage d'une couche semi-conductrice au nitrure par la réalisation d'un premier traitement thermique dans une atmosphère de gaz inerte pour activer le Mg dans la couche semi-conductrice au nitrure ; et
la réalisation d'un traitement de pénétration d'hydrogène formant une première région et une deuxième région qui entoure la première région dans un plan parallèle à la couche semi-conductrice au nitrure et bloque un flux de courant dans la couche semi-conductrice au nitrure, par l'incorporation d'atomes d'hydrogène dans la couche semi-conductrice,
dans lequel le traitement de pénétration d'hydrogène est réalisé après le premier traitement thermique,
dans lequel une composition d'In de la deuxième région est inférieure à une composition d'In de la première région, et
dans lequel une concentration en atomes d'hydrogène de la deuxième région est plus élevée qu'une concentration en atomes d'hydrogène de la première région de deux fois ou plus.
